(19) Europäisches Patentamt
European Patent Office
Office européen des brevets

(11) EP 4 270 066 A1

(12) EUROPEAN PATENT APPLICATION
published in accordance with Art. 153(4) EPC

(43) Date of publication:
**01.11.2023 Bulletin 2023/44**

(21) Application number: **21910964.2**

(22) Date of filing: **23.12.2021**

(51) International Patent Classification (IPC):
***G02B 5/22*** *(2006.01)* ***C08F 220/12*** *(2006.01)*
***C08F 220/32*** *(2006.01)* ***C08L 33/06*** *(2006.01)*

(52) Cooperative Patent Classification (CPC):
**C08F 220/12; C08F 220/32; C08L 33/06; G02B 5/22**

(86) International application number:
**PCT/JP2021/047884**

(87) International publication number:
**WO 2022/138825 (30.06.2022 Gazette 2022/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.12.2020 JP 2020214327**

(71) Applicant: **TOPPAN INC.**
**Tokyo 110-0016 (JP)**

(72) Inventors:
- **IWATA Reiko**
  **Tokyo 110-0016 (JP)**
- **HIRAI Yuri**
  **Tokyo 110-0016 (JP)**
- **YAMADA Akihiro**
  **Amagasaki-shi, Hyogo 660-0095 (JP)**
- **HARA Shuto**
  **Amagasaki-shi, Hyogo 660-0095 (JP)**

(74) Representative: **Hoffmann Eitle**
**Patent- und Rechtsanwälte PartmbB**
**Arabellastraße 30**
**81925 München (DE)**

# (54) COLORED RESIN COMPOSITION, OPTICAL FILTER, AND MANUFACTURING METHOD FOR OPTICAL FILTER

(57) A colored resin component includes a colorant having maximum absorbance in a wavelength band of 700 nm or higher and 1100 nm or lower; a copolymer including a first repeating unit derived from an acrylic monomer having an epoxy group, a second repeating unit derived from a monomer having a phenolic hydroxyl group, and a third repeating unit derived from an acrylic monomer having an aromatic ring, or a third repeating unit derived from an acrylic monomer having an alicyclic structure; and a solvent.

EP 4 270 066 A1

## Description

[Technical Field]

The present disclosure relates to a colored resin composition, an optical filter, and a method of manufacturing the optical filter.

[Background Art]

Digital cameras include solid-state image sensors such as CCD (Charge Coupled Device) image sensors and CMOS (Complementary Metal Oxide Semiconductor) image sensors. Solid-state image sensors have an infrared cut filter. An infrared cut filter absorbs infrared light incident on the infrared cut filter so as to prevent the infrared light from entering photoelectric conversion elements located on the side opposite to the light incident side of the infrared cut filter. This improves the accuracy of visible light detection of the photoelectric conversion element. Therefore, noise included in the light in the visible region detected by the solid-state image sensor is reduced, and as a result, color reproduction of an image captured by the solid-state image sensor can be improved.

A solid-state image sensor capable of detecting not only visible light but also infrared light has been proposed. When the solid-state image sensor is capable of detecting both infrared light and visible light, it includes the above-described infrared cut filter and an infrared transmitting filter.

An infrared cut filter is formed as follows. For example, an infrared cut filter may be formed by adding an inorganic substance that absorbs infrared light to glass. As another example, an infrared cut filter is formed by applying an infrared absorbing substance onto a glass plate. As yet another example, an infrared cut filter is formed using a colored resin composition including an infrared absorbing dye. The method using a colored resin composition is advantageous over the methods using glass in terms of workability of the infrared cut filter and thinning (see, for example, PTL 1).

[Citation List]

[Patent Literature]

[PTL 1] JP 6395293 B

[Summary of the Invention]

[Technical Problem]

When an infrared cut filter is formed using a colored resin composition, a colorant molecule may bind to a nearby colorant molecule in the colored resin composition, and absorb light at a wavelength that falls outside the wavelength band the colorant is originally expected to cover. As a result, an infrared cut filter formed using a colored resin composition may have a reduced absorbance in the wavelength band the colorant is originally expected to cover.

In addition, when an infrared cut filter is being manufactured or used, the colorant forming the infrared cut filter may be heated, which may change the colorant's properties. As a result, the absorbance originating from the colorant of the infrared filter after heating may become lower than the absorbance originating from the colorant of the infrared cut filter before heating.

Further, when a solid-state image sensor including an infrared cut filter is being manufactured, a coating solution for forming another filter may be applied to the infrared cut filter. In such a case, the colorant contained in the infrared cut filter may dissolve into the solvent of the coating solution. This may reduce the expected absorbance originating from the colorant in the infrared cut filter.

An object of the present disclosure is to provide a colored resin composition, an optical filter, and a method of manufacturing the optical filter capable of suppressing decrease in absorbance of a colorant contained in the colored resin composition, decrease in absorbance of a cured film due to heating of the colorant, and decrease in absorbance of a cured film caused by solvent contact with the cured film.

[Solution to Problem]

An aspect of a colored resin composition includes a colorant having maximum absorbance in a wavelength band of 700 nm or higher and 1100 nm or lower; a copolymer including a first repeating unit represented by the following formula (1) and derived from an acrylic monomer having an epoxy group, a second repeating unit derived from a monomer having a phenolic hydroxyl group, and a third repeating unit derived from an acrylic monomer having an aromatic ring

represented by the following formula (2), or a third repeating unit derived from an acrylic monomer having an alicyclic structure represented by the following formula (3); and a solvent.

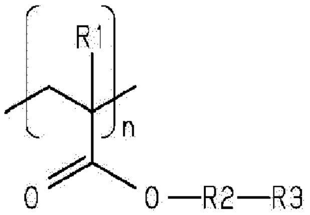

……Formula(1)

In formula (1), R1 is a hydrogen atom or a methyl group, and R2 is a single bond, a linear alkylene group having one or more carbon atoms, a branched alkylene group having three or more carbon atoms, or an oxyalkylene group having one or more carbon atoms. R3 is an epoxy group.

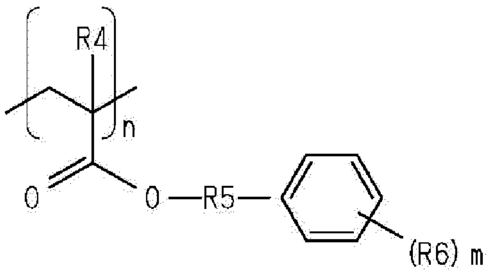

……Formula(2)

In formula (2), R4 is a hydrogen atom or a methyl group, and R5 is a single bond, a linear alkylene group having one or more carbon atoms, a branched alkylene group having three or more carbon atoms, or an oxyalkylene group having one or more carbon atoms. R6 is a hydrogen atom or a substituent. In formula (2), m is an integer of 1 to 5 when R6 is a substituent.

In formula (3), R7 is a hydrogen atom or a methyl group, and R8 is a single bond, a linear alkylene group having one or more carbon atoms, a branched alkylene group having three or more carbon atoms, or an oxyalkylene group having one or more carbon atoms. In formula (3), R9 is an alicyclic structure having three or more carbon atoms.

An aspect of the optical filter is an optical filter formed using the above colored resin composition. It includes the colorant and the copolymer.

An aspect of a method for manufacturing the optical filter includes applying a coating solution prepared using a colored resin composition including a colorant, a copolymer, and a solvent to a substrate, and curing the coating solution. The colorant has maximum absorbance in a wavelength band of 700 nm or higher and 1100 nm or lower, and the copolymer includes first, second, and third repeating units. The first repeating unit is represented by the above formula (1) and derived from an acrylic monomer having an epoxy group, the second repeating unit is derived from a monomer having a phenolic hydroxyl group, and the third repeating unit is derived from an acrylic monomer having an aromatic ring represented by the above formula (2), or derived from an acrylic monomer having an alicyclic structure represented by the above formula (3).

[Description of Embodiments]

[Colored resin composition]

A colored resin composition of the present disclosure includes a colorant, a copolymer, and a solvent. The colorant has maximum absorbance in a wavelength band of 700 nm or higher and 1100 nm or lower. The copolymer includes first, second, and third repeating units. The first repeating unit is represented by the following formula (1) and is derived from an acrylic monomer having an epoxy group. The second repeating unit is derived from a monomer having a phenolic hydroxyl group. The third repeating unit is derived from an acrylic monomer having an aromatic ring represented by the following formula (2), or derived from an acrylic monomer having an alicyclic structure represented by the following formula (3).

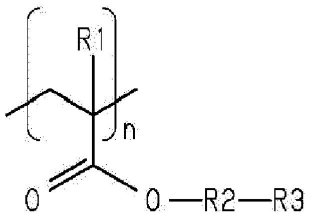

······Formula(1)

In formula (1), R1 is a hydrogen atom or a methyl group, and R2 is a single bond, a linear alkylene group having one or more carbon atoms, a branched alkylene group having three or more carbon atoms, or an oxyalkylene group having one or more carbon atoms. R3 is an epoxy group.

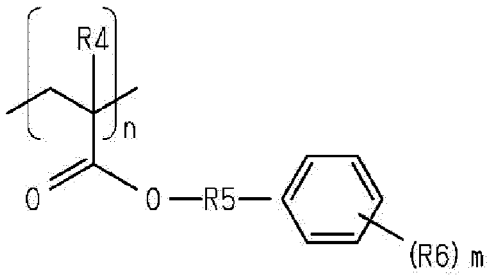

······Formula(2)

In formula (2), R4 is a hydrogen atom or a methyl group, and R5 is a single bond, a linear alkylene group having one or more carbon atoms, a branched alkylene group having three or more carbon atoms, or an oxyalkylene group having one or more carbon atoms. R6 is a hydrogen atom or a substituent. In formula (2), m is an integer of 1 to 5 when R6 is a substituent.

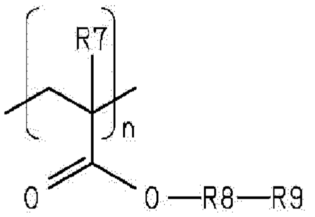

······Formula(3)

In formula (3), R7 is a hydrogen atom or a methyl group, and R8 is a single bond, a linear alkylene group having one or more carbon atoms, a branched alkylene group having three or more carbon atoms, or an oxyalkylene group having one or more carbon atoms. In formula (3), R9 is an alicyclic structure having three or more carbon atoms.

The copolymer includes the first and second repeating units. Since the epoxy group of the first repeating unit and the phenolic hydroxyl group of the second repeating unit form a crosslinked structure in the heating step performed to form the cured film, it is possible to prevent the heating from changing the absorbance of the cured film. In addition, since the first and second repeating units form a crosslinked structure, it is possible to prevent the dye, which is the colorant, from dissolving from the cured film when it comes into contact with the solvent used to stack another layer onto the cured film. Therefore, because the copolymer of the colored resin composition includes the first and second repeating units, the cured film formed using the colored resin composition, that is, the optical filter can have improved heat resistance and solvent resistance.

The copolymer further includes the third repeating unit. The aromatic ring or alicyclic structure of the third repeating unit can create a distance between molecules of the dye, which is the colorant, close to each other that is long enough to prevent association between them by placing itself between them. This suppresses deterioration of spectral characteristics at the wavelengths at which the dye is expected to absorb light. As a result, a decrease in absorbance of the colorant in the colored resin composition can be suppressed. Further, a decrease in absorbance of a cured film formed using the colored resin composition can be suppressed.

An optical filter formed using a colored resin composition may be placed adjacent to another filter in an object to which the optical filter is applied. When the colorant contained in the colored resin composition is a dye, part of the colorant in the optical filter may migrate into another filter adjacent to the optical filter due to the passage of time, heating of the object, or the like, resulting in a decrease in the absorbance of the optical filter. In this regard, according to the optical filter using the colored composition of the present disclosure, since the phenolic hydroxyl group forms a crosslinked

structure with the epoxy group when the optical filter, which is a cured film, is formed, it is possible to prevent the colorant contained in the optical filter from migrating into another filter. As a result, a decrease in absorbance of the optical filter can be suppressed.

The colorant, copolymer, and solvent that the colored resin composition includes will now be described in order.

[Colorant]

As described above, the colorant has maximum absorbance in a wavelength band of 700 nm or higher and 1100 nm or lower. The molar absorption coefficient ε ($mol^{-1} \cdot L \cdot cm^{-1}$) at the maximum absorbance wavelength of the colorant preferably satisfies the following expression.

$$\varepsilon \geq 3.0 \times 10^4$$

Along with the reduction in size and weight of image display devices and solid-state image sensors, optical filters for optical sensors used in image display devices and solid-state image sensors are being required to have a film thickness of several hundred nm or greater and several μm or smaller.

When the colorant has a molar absorption coefficient of $3.0 \times 10^4$ or higher, a colored resin composition capable of achieving the absorbance required for a thin-film optical filter can be prepared. For example, it is possible to prepare a colored resin composition for an optical filter having a thickness of 1 μm so that the transmittance at the maximum absorbance wavelength of the colorant is 10% or lower. In addition, since the proportion of the colorant to the total amount of the colored resin composition can be reduced, the colored resin composition can contain the copolymer, solvent, and the like in a larger amount. This makes it possible to increase the amount of colorant that can be dissolved in the solvent. Note that, since the proportion of the colorant to the total amount of the colored resin composition can be reduced, the colored resin composition can contain component(s) other than a colorant, copolymer, and solvent. The other component may be, for example, a crosslinking agent or a polymerizable monomer.

On the other hand, when the molar absorption coefficient of the colorant is lower than $3.0 \times 10^4$, the colored resin composition needs to contain a large amount of colorant in order for it to exhibit a predetermined absorbance, which makes it difficult to put enough copolymer in the colored resin composition to have the desired viscosity. As a result, it is difficult to form a coating film having a desired thickness and, in turn, an optical filter.

The colorant may be, for example, any one of cyanine dyes, phthalocyanine dyes, squarylium dyes, croconium dyes, diimmonium dyes, dithiol metal complex dyes, naphthalocyanine dyes, oxonol dyes, and pyrromethene dyes. Note that these colorants are dyes.

The colorant is preferably a cyanine dye because of its high solubility in a solvent and high molar absorption coefficient. The cyanine dye includes a cation having polymethine and a nitrogen-containing heterocyclic ring at each terminal end of the polymethine, and a tris(pentafluoroethyl)trifluorophosphate anion. The cyanine dye may have a structure represented by formula (4) below.

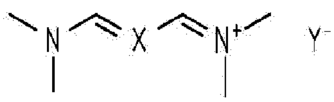

······Formula(4)

In formula (4) above, X is a single methine or polymethine. The hydrogen atom bonded to the carbon atom of the methine may be substituted with a halogen atom or an organic group. The polymethine may have a cyclic structure containing carbon atoms forming the polymethine. The cyclic structure can include three consecutive carbons among the carbon atoms forming the polymethine. When the polymethine has a cyclic structure, the polymethine may have five or more carbon atoms. Each nitrogen atom is included in a five- or six-membered heterocycle. The heterocycles may be fused. In the above formula (4), $Y^-$ is an anion.

The cyanine dye may have a structure represented by formula (5) below.

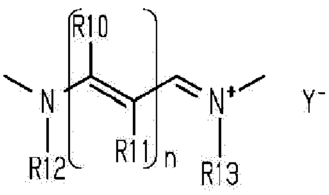

······Formula(5)

In the above formula (5), n is an integer greater than or equal to one. It indicates the number of repeating units included in the polymethine chain. R10 and R11 are a hydrogen atom or organic group. R12 and R13 are a hydrogen atom or organic group. R12 and R13 are preferably a linear alkyl group having one or more carbon atoms or a branched alkyl group. Each nitrogen atom is included in a five- or six-membered heterocycle. The heterocycles may be fused.

In formula (4), when the polymethine includes a cyclic structure, the cyclic structure may have, for example, at least one unsaturated bond such as an ethylenic double bond, and the unsaturated bond may undergo electron resonance as part of the polymethine chain. Such a cyclic structure may be, for example, a cyclopentene ring, cyclopentadiene ring, cyclohexene ring, cyclohexadiene ring, cycloheptene ring, cyclooctene ring, cyclooctadiene ring, or benzene ring. These cyclic structures may have a substituent.

The compound is cyanine when n is 1 in formula (5), the compound is carbocyanine when n is 2, and the compound is dicarbocyanine when n is 3. The compound is tricarbocyanine when n is 4 in formula (5).

Examples of the organic groups for R10 and R11 include alkyl groups, aryl groups, aralkyl groups, and alkenyl groups. The alkyl group may be, for example, a methyl group, ethyl group, propyl group, isopropyl group, n-butyl group, sec-butyl group, isobutyl group, tert-butyl group, isopentyl group, neopentyl group, hexyl group, cyclohexyl group, octyl group, nonyl group, or decyl group. The aryl group may be, for example, a phenyl, tolyl, xylyl, or naphthyl group. The aralkyl group may be, for example, a benzyl, phenylethyl, or phenylpropyl group. The alkenyl group may be, for example, a vinyl group, allyl group, propenyl group, isopropenyl group, butenyl group, hexenyl group, cyclohexenyl group, or octenyl group.

At least part of the hydrogen atoms of an organic group may be substituted with a halogen atom or a cyano group. The halogen atom may be fluorine, bromine, or chlorine. The organic group after substitution may be, for example, a chloromethyl group, chloropropyl group, bromoethyl group, trifluoropropyl group, or cyanoethyl group.

R12 or R13 may be, for example, a methyl group, ethyl group, propyl group, isopropyl group, n-butyl group, sec-butyl group, isobutyl group, tert-butyl group, isopentyl group, neopentyl group, hexyl group, cyclohexyl group, octyl group, nonyl group, or decyl group.

The heterocycles each having a nitrogen atom may be, for example, pyrrole, imidazole, thiazole, or pyridine.

The cations in such a cyanine dye may have, for example, the structure represented by the following formula (6) or (7).

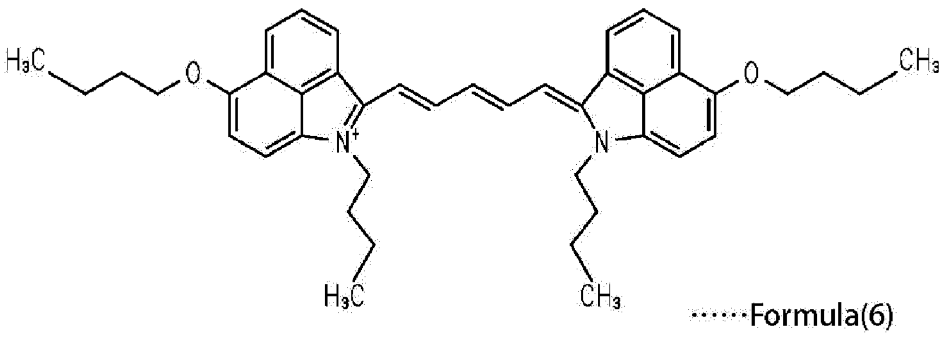

······Formula(6)

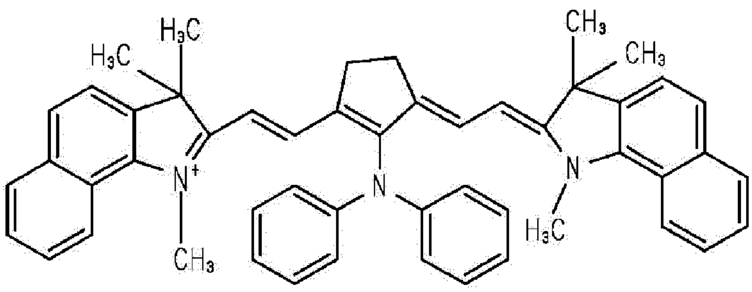

······Formula(7)

The cations in such a cyanine dye may have, for example, the structure represented by the following formulas (8) to (47). That is, the nitrogen atoms in the cyanine dye may be included in the cyclic structures shown below.

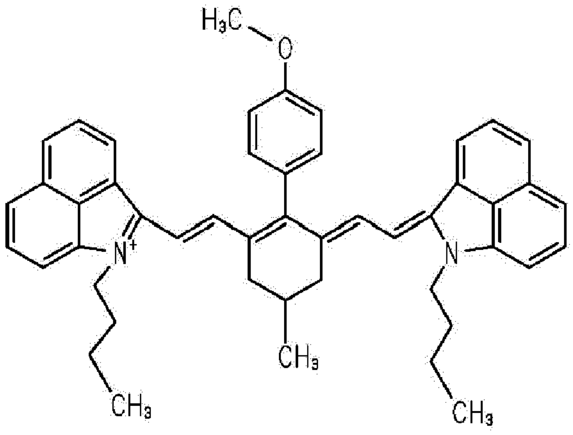

······Formula(8)

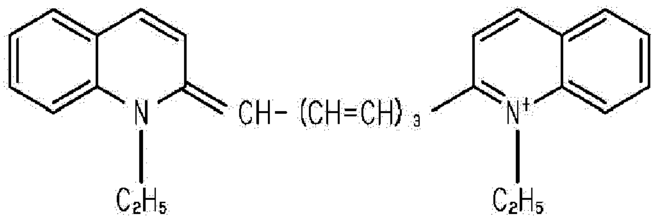

······Formula(9)

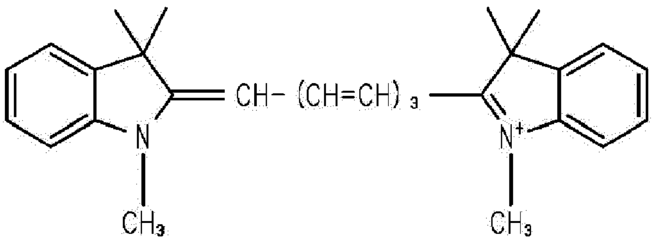

······Formula(10)

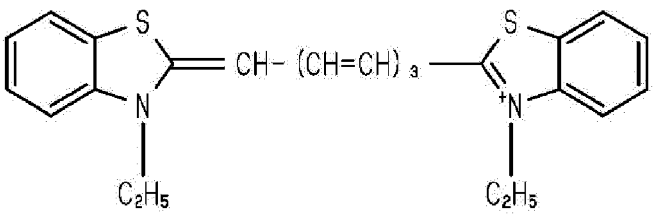

······Formula(11)

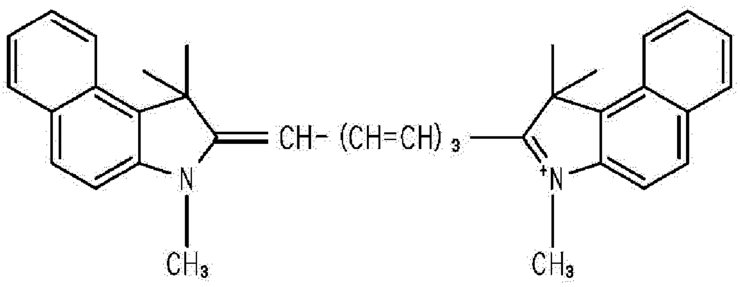

······Formula(12)

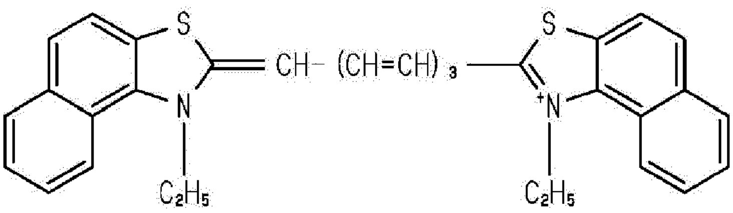

······Formula(13)

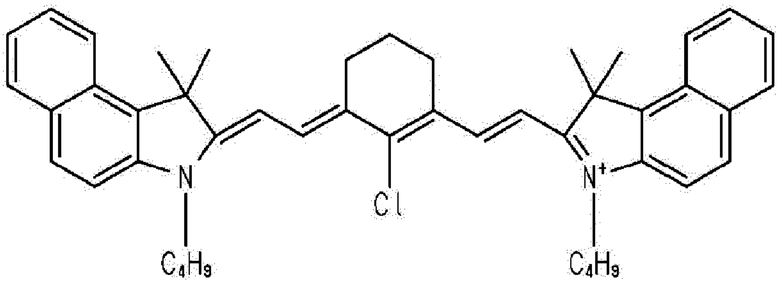

······Formula(14)

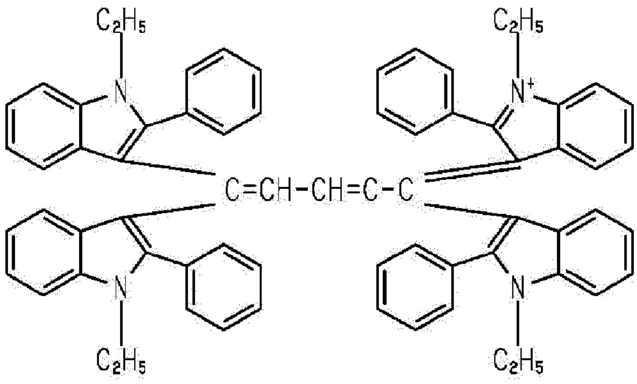

···Formula(15)

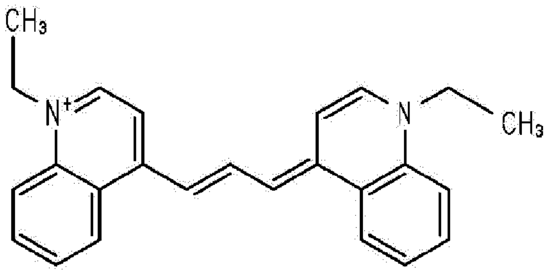

······Formula(16)

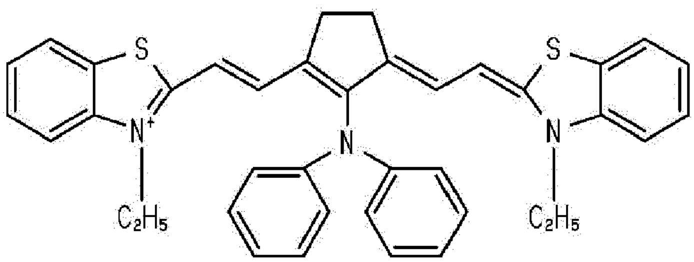

······Formula(17)

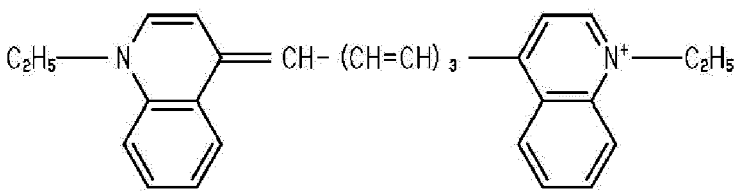

······Formula(18)

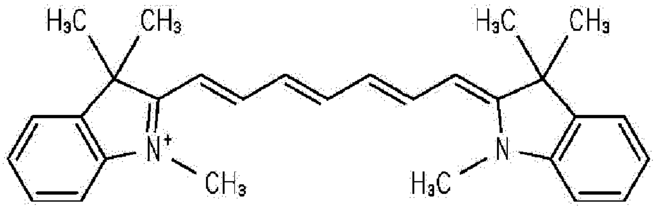

······Formula(19)

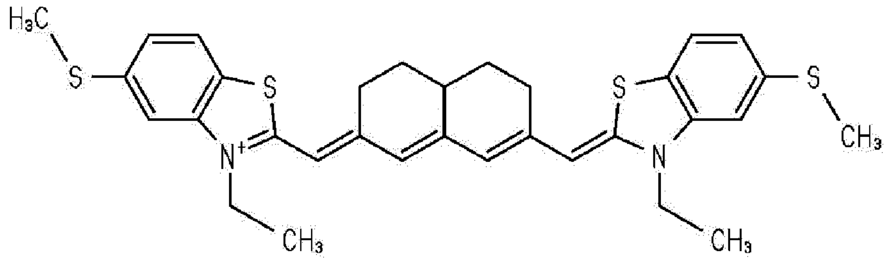

······Formula(20)

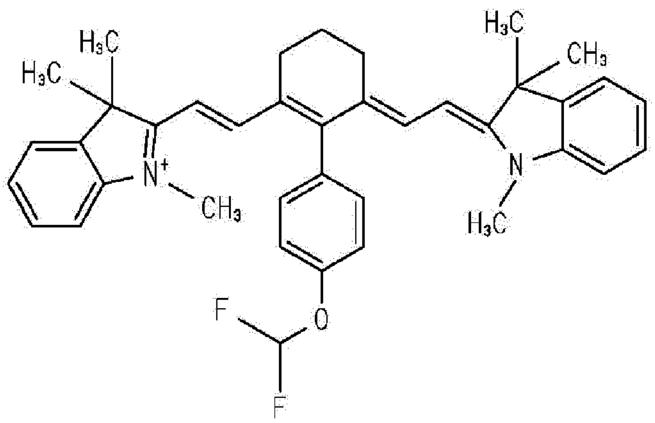

······Formula(21)

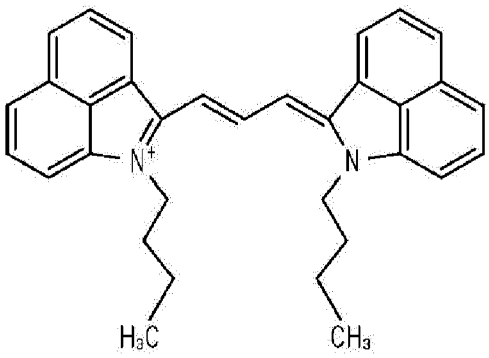

······Formula(22)

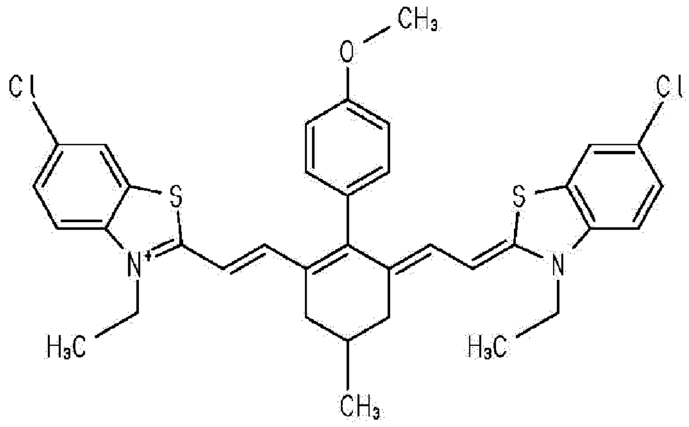

······Formula(23)

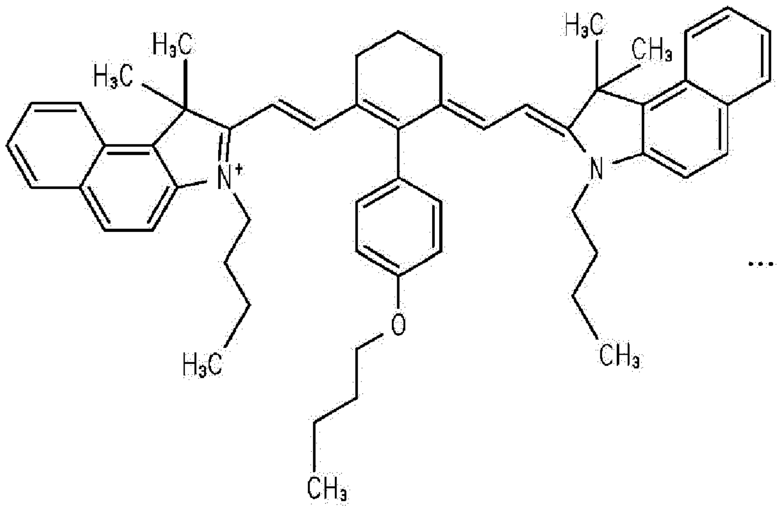

······Formula(24)

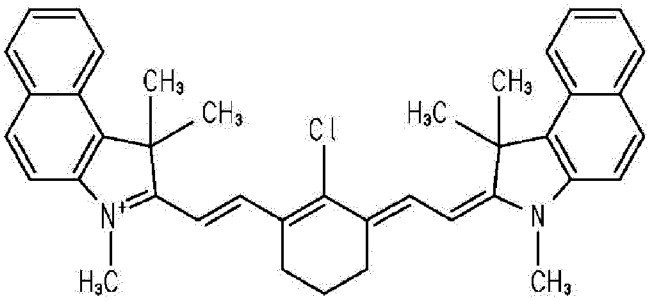

······Formula(25)

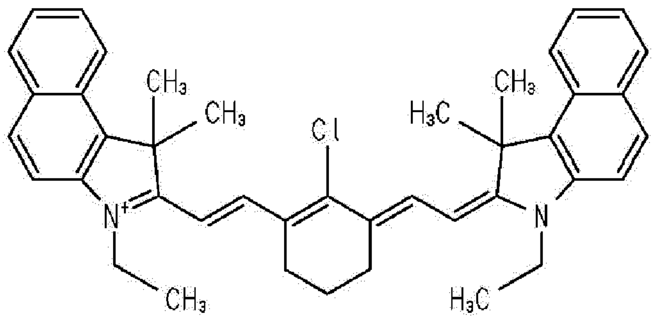

······Formula(26)

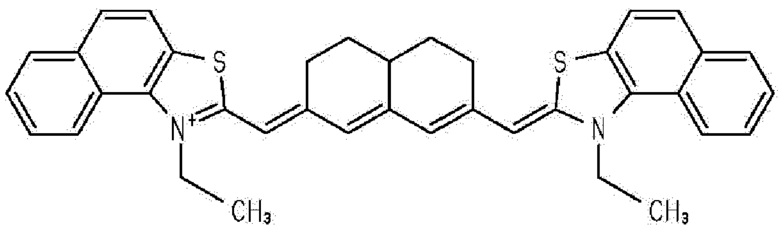

······Formula(27)

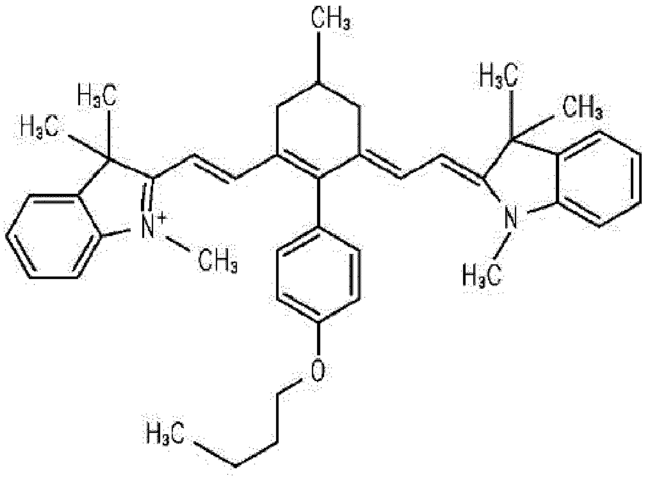

• • • • • • Formula(28)

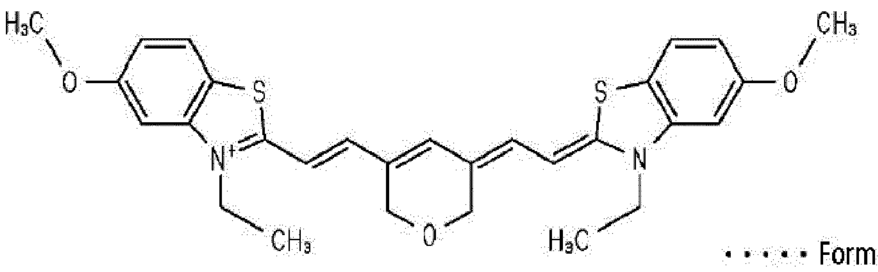

• • • • • Formula(29)

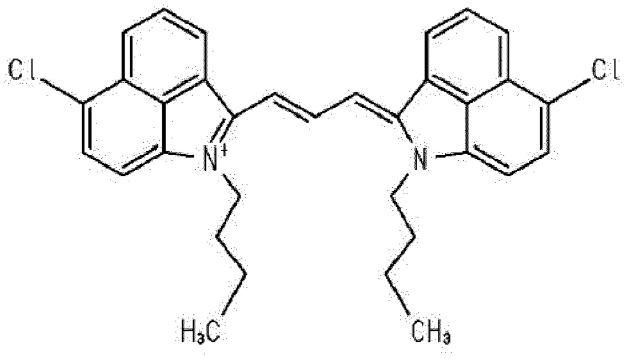

• • • • • •Formula(30)

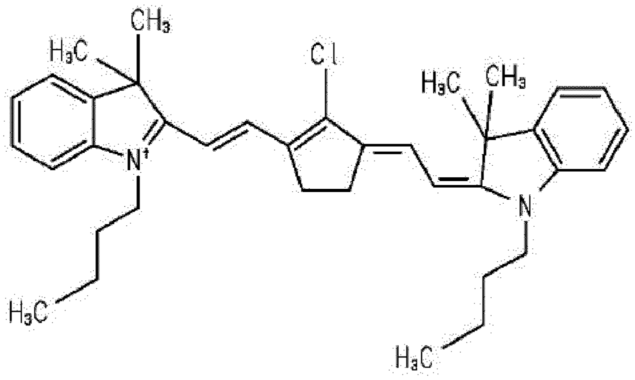

······Formula(31)

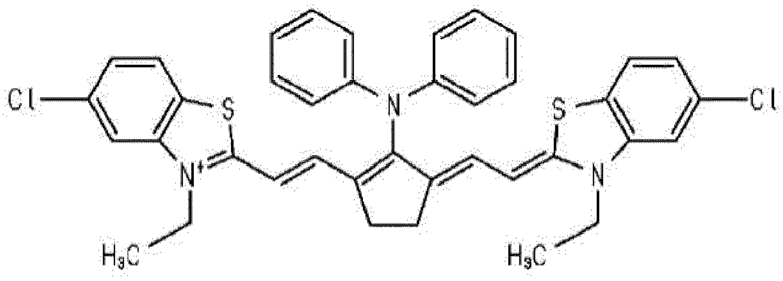

·····Formula(32)

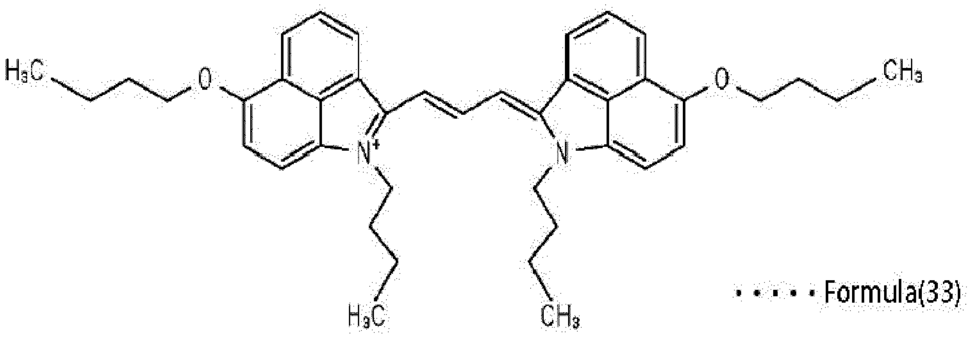

·····Formula(33)

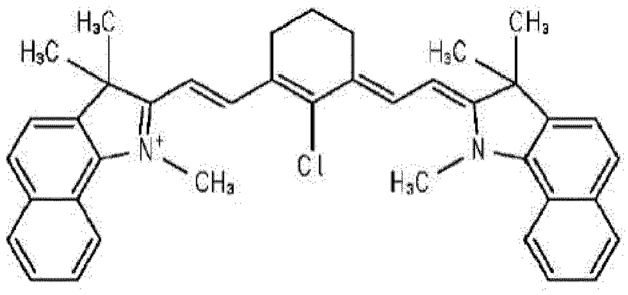

······Formula(34)

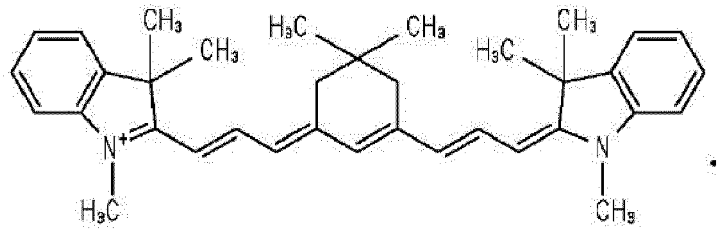

······Formula(35)

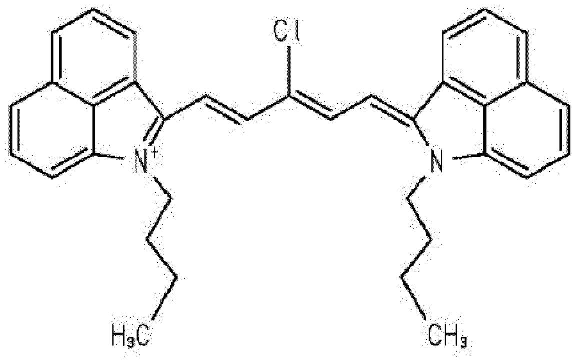

• • • • • • Formula(36)

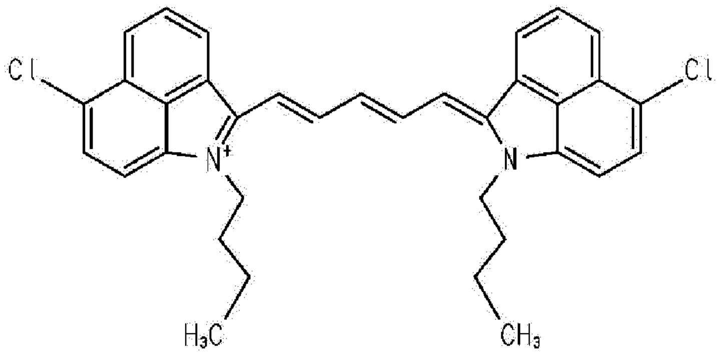

• • • • • • Formula(37)

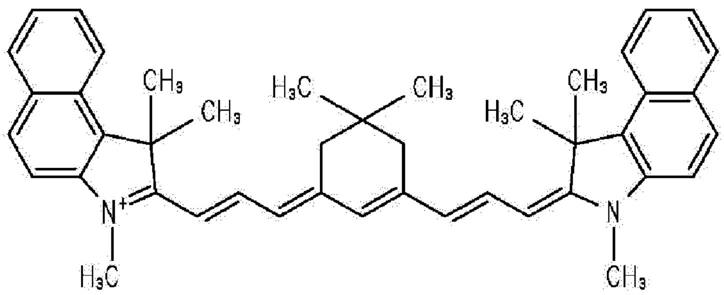

• • • • • •Formula(38)

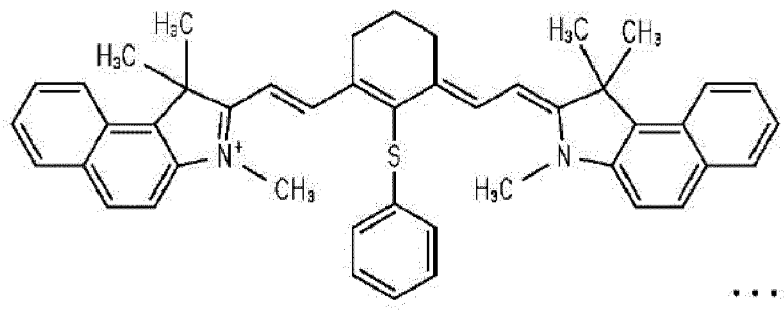

• • • • • Formula(39)

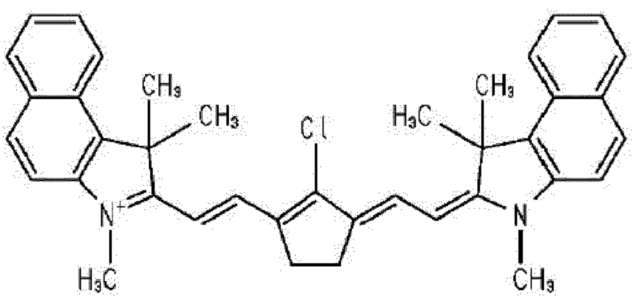

• • • • • • Formula(40)

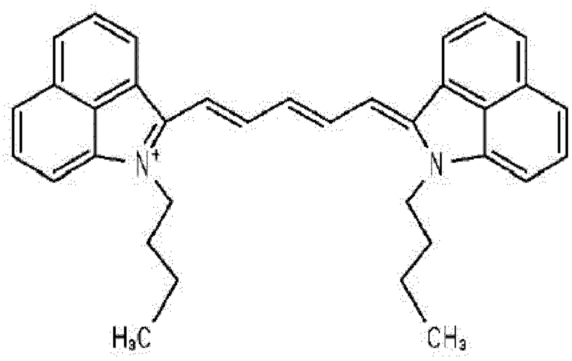

······ Formula(41)

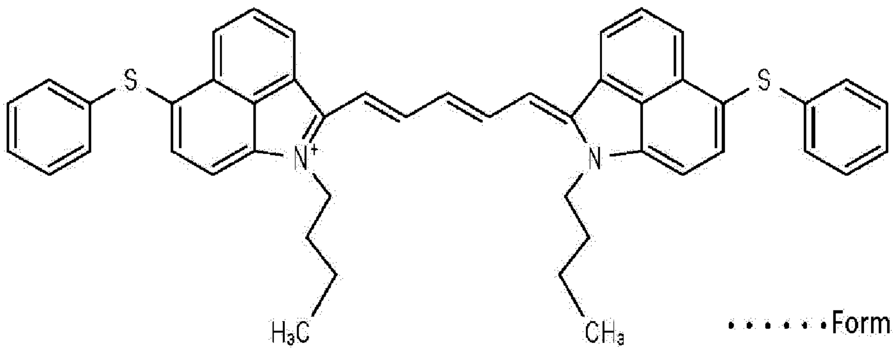

······Formula(42)

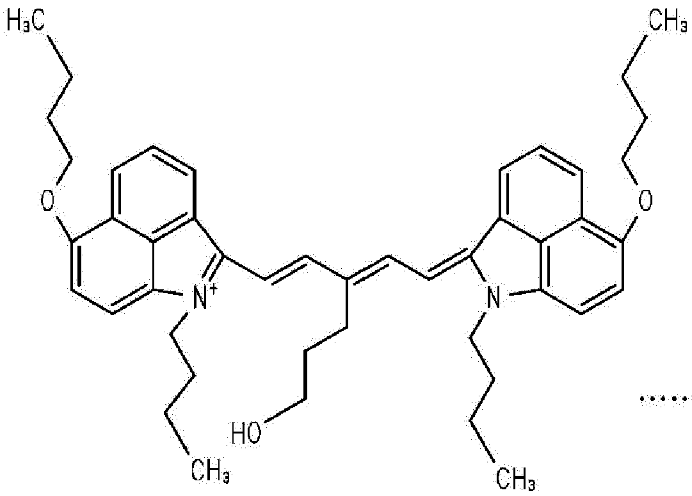

······Formula(43)

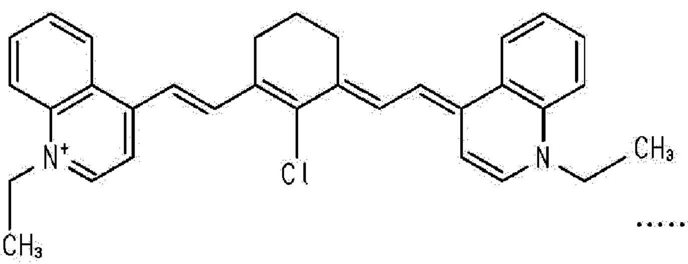

······Formula(44)

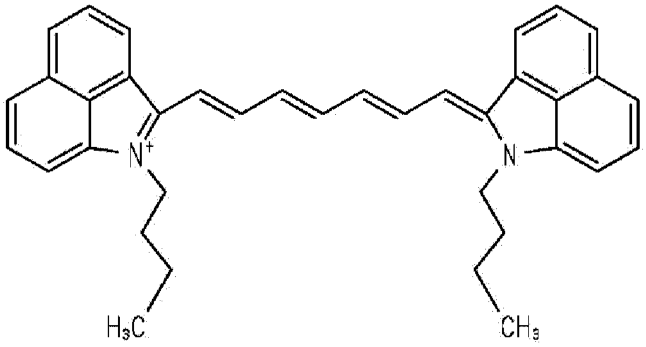

……Formula(45)

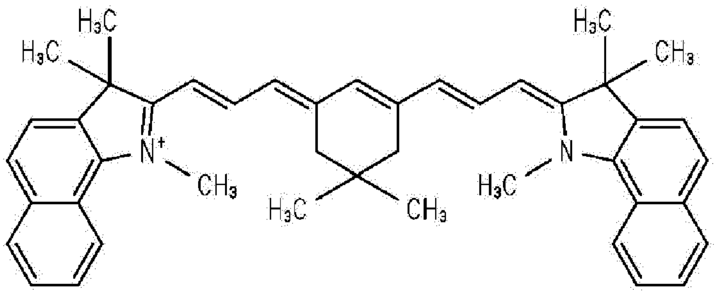

……Formula(46)

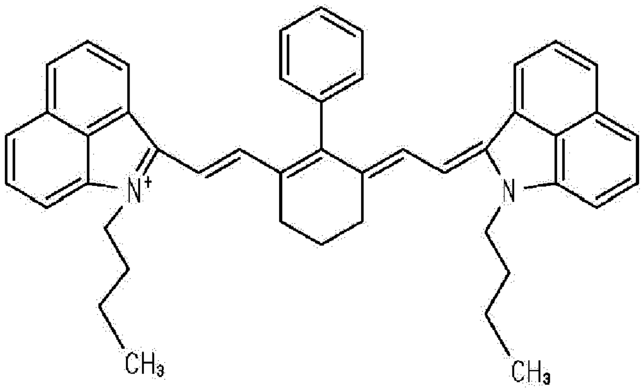

……Formula(47)

In the above formula (4), $Y^-$ is, for example, tris(pentafluoroethyl)trifluorophosphate anion ($[(C_2F_5)_3PF_3]^-$) (FAP). FAP has the structure represented by the following formula (48).

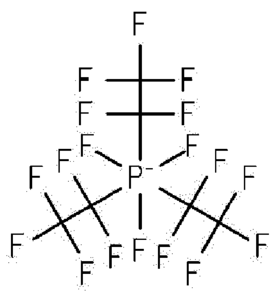

……Formula(48)

When the optical filter is formed using a colored resin composition, the coating solution containing the colored resin composition is heated to about 200°C to form the optical filter, which is the cured film, from the coating film. When the cyanine dye is heated to about 200°C, the absorbance of the cyanine dye may change as a result of the structure of the cyanine dye after heating changing from the structure thereof before heating.

Since the FAP has a molecular weight and molecular structure that allow it to be located near the polymethine

chain of the cyanine dye, it is possible to prevent the polymethine chain of the cyanine dye from being cut due to the cyanine dye being heated. Therefore, a change in the absorbance of the cyanine dye due to the heating of the cyanine dye is suppressed, and as a result, a change in the absorbance of the cured film formed of the colored resin composition can be suppressed.

[Copolymer]

As described above, the colored resin composition includes a copolymer. The copolymer may include a repeating unit derived from a monomer including an ethylenic double bond. Examples of monomers including ethylenic double bonds include ethylene compounds, maleimide compounds, acrylates, and methacrylate compounds. According to these monomers, a plurality of monomers are polymerized using the ethylenic double bonds in the monomers. A copolymer is thus obtained.

The copolymer includes first, second, and third repeating units. The first repeating unit is derived from an acrylic monomer having an epoxy group. The second repeating unit is derived from a monomer having a phenolic hydroxyl group. The third repeating unit is derived from an acrylic monomer having an aromatic ring or an acrylic monomer having an alicyclic ring.

The first repeating unit is derived from a first monomer that is an acrylic monomer having an epoxy group, and has a structure represented by the following formula (1).

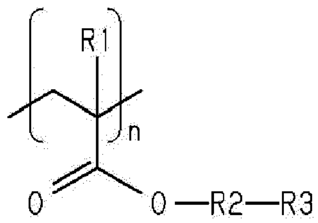

······Formula(1)

As described above, in the first repeating unit, R1 is a hydrogen atom or a methyl group, and R2 is a single bond, a linear alkylene group having one or more carbon atoms, a branched alkylene group having three or more carbon atoms, or an oxyalkylene group having one or more carbon atoms. R2 may be, for example, a methylene group, an ethylene group, a trimethylene group, a propylene group, or a butylene group. R3 is an epoxy group.

Examples of the first monomer include glycidyl (meth)acrylate, 2-methylglycidyl (meth)acrylate, 3,4-epoxycyclohexylmethyl (meth)acrylate, and 4-hydroxybutyl (meth)acrylate glycidyl ether. Considering the reactivity of the acrylic monomer, the acrylic monomer is preferably glycidyl (meth)acrylate, 3,4-epoxycyclohexylmethyl (meth)acrylate, or 4-hydroxybutyl (meth)acrylate glycidyl ether, more preferably glycidyl (meth)acrylate, and particularly preferably glycidyl methacrylate. These acrylic monomers are also preferably in that they are easily available.

The second repeating unit is derived from a second monomer that is a monomer having a phenolic hydroxyl group. Phenolic hydroxyl groups have high reactivity with epoxy groups. Phenolic hydroxyl groups react with epoxy groups and form a crosslinked structure, which enhances the heat resistance and solvent resistance of an optical filter containing the copolymer. Since phenolic hydroxyl groups are mildly acidic, they do not easily undergo a crosslinking reaction with the epoxy groups during the formation of the copolymer. On the other hand, phenolic hydroxyl groups and epoxy groups undergo a crosslinking reaction when a coating film formed of a coating solution containing the copolymer is heated. Therefore, when compared with the case where the copolymer has a crosslinked structure resulting from a crosslinking reaction that has occurred prior to the formation of the coating film, the viscosity of the coating solution is likely to be low. This makes it easier to apply the coating solution.

Examples of the second monomer include 4-hydroxystyrene, p-isopropenylphenol, 4-hydroxyphenyl (meth)acrylate, 4-hydroxybenzyl (meth)acrylate, 4-hydroxyphenityl (meth)acrylate, and N-hydroxyphenylmaleimide. Considering the reactivity of the monomer, the second monomer is preferably hydroxystyrene, 4-hydroxyphenyl (meth)acrylate, 4-hydroxybenzyl (meth)acrylate, or N-hydroxyphenylmaleimide, more preferably 4-hydroxyphenyl (meth)acrylate or N-hydroxyphenyl maleimide, and particularly preferably 4-hydroxyphenyl methacrylate. A copolymer produced using a monomer having a phenolic hydroxyl group has a phenolic hydroxyl group in its side chain.

The copolymer further includes a third repeating unit. The third repeating unit is derived from a third monomer that is an acrylic monomer having an aromatic ring, or a third monomer that is an acrylic monomer having an alicyclic structure. The third monomer having an aromatic ring has the structure represented by the following formula (2). The third monomer having an alicyclic structure has the structure represented by the following formula (3).

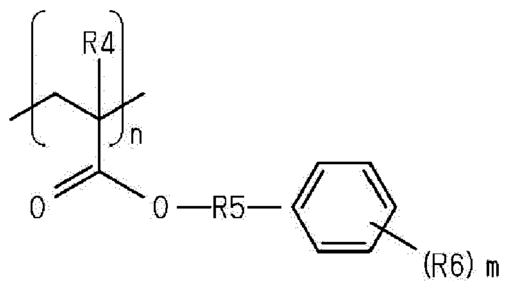

……Formula(2)

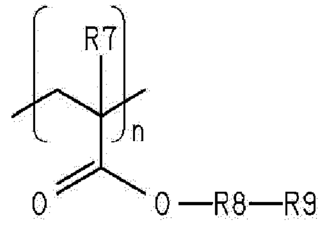

……Formula(3)

Examples of the third monomer having an aromatic ring include benzyl (meth)acrylate, phenyl (meth)acrylate, phenethyl (meth)acrylate, phenoxyethyl (meth)acrylate, phenoxypolyethylene glycol (meth)acrylate, 2-hydroxy-3-phenoxypropyl (meth)acrylate, o-phenoxyphenylethyl (meth)acrylate, 2-naphthyl (meth)acrylate, and 9-anthrylmethyl (meth)acrylate. To suppress a change in the spectral characteristics of the dye, the third monomer is preferably benzyl (meth)acrylate, phenyl (meth)acrylate, phenethyl (meth)acrylate, or phenoxyethyl (meth)acrylate, more preferably phenyl (meth)acrylate, and particularly preferably phenyl methacrylate.

Examples of the third monomer having an alicyclic structure include cyclohexyl (meth)acrylate, isobornyl (meth)acrylate, dicyclopentenyl (meth)acrylate, dicyclopentenyloxyethyl (meth)acrylate, dicyclopentanyl (meth)acrylate, and 4-t-butylcyclohexyl (meth)acrylate.

The copolymer preferably has the first repeating unit in a proportion of 7.5% by weight or higher and 17.5% by weight or lower relative to the total weight of the copolymer, and, in the copolymer, the ratio (W2/W1) of the weight (W2) of the second repeating unit to the weight (W1) of the first repeating unit is 1.0% by weight or higher and 3.0% by weight or lower. When the proportions of the first and second repeating units in the copolymer are in the above ranges, it is possible to suppress a decrease in the absorbance of the cured film after the heat treatment for forming the cured film, as well as when the cured film comes into contact with a solvent.

The copolymer preferably contains 65% by weight or more third repeating unit with respect to the total weight of the copolymer. When the proportion of the third repeating unit in the copolymer is within the above range, it is possible to prevent association between colorants during the formation of the cured film, and prevent the spectral characteristics from deteriorating at the wavelengths at which the colorant is expected to absorb light.

The glass transition temperature of the copolymer is preferably 75°C or higher, and more preferably 100°C or higher. With a glass transition temperature of 75°C or higher, when the cured film is formed using the colored resin composition of the present disclosure, it is possible to prevent the spectral characteristics from deteriorating more reliably at the wavelengths at which the colorant contained in the formed cured film is expected to absorb light.

The molecular weight of the copolymer is preferably 30,000 or higher and 150,000 or lower, and more preferably 50,000 or higher and 150,000 or lower. When the molecular weight of the copolymer is within this range, when the cured film is formed using the colored resin composition of the present disclosure, it is possible to prevent the spectral characteristics from deteriorating more reliably at the wavelengths at which the colorant contained in the formed cured film is expected to absorb light.

If the copolymer has a molecular weight exceeding 150,000, the viscosity of the copolymer increases during the formation of the copolymer. This makes it difficult to form a coating solution using the copolymer. Therefore, when the molecular weight of the copolymer exceeds 150,000, the film cannot be easily formed. On the other hand, when the molecular weight of the copolymer is 150,000 or lower, a film can be formed more easily since a coating solution can be formed. The average molecular weight of the copolymer is weight average molecular weight. The weight average molecular weight of the copolymer can be measured using, for example, gel permeation chromatography.

The copolymer may include a monomer other than the above-described first, second, and third monomers. Examples of monomers other than the first, second, and third monomers include (meth)acrylic acid alkyl ester compounds, aromatic alkenyl compounds, vinyl cyanide compounds, acrylamide compounds, and maleimide compounds.

Examples of (meth)acrylic acid alkyl ester compounds include methyl (meth)acrylate, ethyl (meth)acrylate, n-butyl (meth)acrylate, iso-butyl (meth)acrylate, tert-butyl (meth)acrylate, n-hexyl (meth)acrylate, n-octyl (meth)acrylate,

2-ethylhexyl (meth)acrylate, decyl (meth)acrylate, dodecyl (meth)acrylate, and stearyl (meth)acrylate. Examples of aromatic alkenyl compounds include styrene, α-methylstyrene, p-methylstyrene, and p-methoxystyrene. Examples of vinyl cyanide compounds include acrylonitrile and methacrylonitrile. Examples of acrylamide compounds include acrylamide and methacrylamide. Examples of maleimide compounds include N-cyclohexylmaleimide and N-phenylmaleimide.

[Solvent]

As described above, the colored resin composition includes a solvent. The solvent makes it possible to adjust the viscosity of the colored resin composition including the colorant and copolymer. This makes it easier to apply a coating solution containing the colored resin composition when forming the cured film using the colored resin composition.

The solvent preferably satisfies the following conditions: is compatible with the colorant and copolymer, is volatile enough to volatilize in the process of forming the cured film, and does not make the cured film uneven when the solvent volatilizes. The solvent may be an ester solvent, alcohol ether solvent, ketone solvent, aromatic solvent, amide solvent, or alcohol solvent.

The ester solvent may be, for example, methyl acetate, ethyl acetate, n-butyl acetate, isobutyl acetate, t-butyl acetate, methyl lactate, ethyl lactate, or propylene glycol monomethyl ether acetate. The alcohol ether solvent may be, for example, ethylene glycol monomethyl ether, ethylene glycol monoethyl ether, propylene glycol monomethyl ether, propylene glycol monoethyl ether, 3-methoxy-1-butanol, or 3-methoxy-3-methyl-1-butanol. The ketone solvent may be, for example, acetone, methyl ethyl ketone, methyl isobutyl ketone, or cyclohexanone. The aromatic solvent may be, for example, benzene, toluene, or xylene. The amide solvent may be, for example, formamide or dimethylformamide. The alcohol solvent may be, for example, methanol, ethanol, n-propanol, isopropanol, n-butanol, isobutanol, s-butanol, t-butanol, diacetone alcohol, or 2-methyl-2-butanol.

[Colored resin composition]

The contents of the colorant, copolymer, and solvent in the colored resin composition can be determined as appropriate according to the purpose for which the colored composition is used. For example, when the total amount of the colorant, copolymer, and solvent contained in the colored composition is set to 100 parts by weight, the weight of the copolymer is preferably 10 parts by weight or more and 70 parts by weight or less.

In the colored resin composition, the percentage ($100 \times WC/WS$) of the weight (WC) of the colorant to the weight (WS) of the solvent is preferably 0.6% by weight or more and 30% by weight or less.

As described above, optical filters used in image display devices, solid-state image sensors, and the like are required to have a thickness of several hundred nm or greater and several μm or smaller. In order to achieve a desired absorbance with a thin optical filter, a predetermined amount or more of a colorant needs to be dissolved in the solvent of the colored resin composition for forming the optical filter.

In this regard, when the percentage of the weight of the colorant dissolved in the solvent to the weight of the solvent is 0.6% by weight or more, the thin-film optical filter can have sufficient absorbance as an optical filter. On the other hand, when the percentage of the weight of the colorant dissolved in the solvent to the weight of the solvent is 30% by weight or less, it is possible to prevent the colorant dissolved in the solvent from precipitating and remaining on the surface of the optical filter due to the solvent volatilizing during the formation of the optical filter.

Note that, since the colorant is dissolved in the solvent, it is possible to prevent the colorant from precipitating when the optical filter is formed and thereby reducing the transparency of the optical filter. In addition, because it is possible to suppress the occurrence of irregularities on the surface of the optical filter due to the colorant-containing precipitate, variation in the thickness of the optical filter can be suppressed.

The colored resin composition can include an additive in addition to the colorant, copolymer, and solvent. Examples of additives include leveling agents, antioxidants, light stabilizers, and antistatic agents.

[Method of manufacturing copolymer]

Using a mixture of monomers including at least the first, second, and third monomers, a copolymer can be obtained by polymerizing the first, second, and third monomers. An example of the method of polymerizing the monomers is radical polymerization. Radical polymerization includes solution polymerization, suspension polymerization, and emulsion polymerization. Among these, solution polymerization is preferably used to polymerize the first, second, and third monomers. According to the solution polymerization, the weight average molecular weight of the copolymer can be easily adjusted.

Polymerization solvents that can be used in solution polymerization are solvents in which the monomers and the polymerization initiator can dissolve. Examples of polymerization solvents include methanol, ethanol, 1-propanol, acetone, methyl ethyl ketone, and propylene glycol monomethyl ether.

The percentage (100 × WM/WS) of the total weight (WM) of the monomers to the weight (WS) of the polymerization solvent is preferably 10% by weight or more and 60% by weight or less, more preferably 20% by weight or more and 50% by weight or less. When the percentage is 20% by weight or more, it is possible to prevent the monomers from remaining and the molecular weight of the resulting copolymer from decreasing. Further, when the percentage is 60% by weight or less, heat generation of the solution can be controlled more easily.

Note that, in addition to the concentrations of the monomers in the polymerization solution, the concentration of the radical polymerization initiator in the polymerization solution can be adjusted to control the molecular weight of the copolymer.

The polymerization initiator may be, for example, an organic peroxide or an azo polymerization initiator. Examples of organic peroxides include di(4-t-butylcyclohexyl)peroxydicarbonate and 1,1,3,3-tetramethylbutylperoxy-2-ethylhexanoate. The azo polymerization initiator may be, for example, 2,2'-azobisisobutyronitrile. In the polymerization reaction, one or more kinds of the polymerization initiators exemplified herein may be used. The amount of the polymerization initiator to be used can be set as appropriate according factors such as the combination of monomers to be polymerized and the conditions of the polymerization reaction.

When adding the monomers to the polymerization solvent, for example, the total amount of the monomers may be added to the polymerization solvent at once. Alternatively, portions of the monomers may be added to the polymerization solvent, and the remaining portions may be added dropwise into the polymerization solvent. Alternatively, the monomers may be added to the polymerization solvent by dropping the total amount of the monomers into the polymerization solvent. When adding the monomers to the polymerization solvent, it is preferable to drop at least part of the total amount of the monomers into the polymerization solvent. This facilitates controlling the heat generated by the polymerization reaction as compared with when the total amount of the monomers is added to the polymerization solvent at once.

When adding the polymerization initiator to the polymerization solvent, for example, the total amount of the polymerization initiator may be added to the polymerization solvent at once. Alternatively, a portion of the polymerization initiator may be added to the polymerization solvent, and the remaining portion may be added dropwise into the polymerization solvent. Alternatively, the total amount of the polymerization initiator may be added dropwise into the polymerization solvent. It is preferable to drop the polymerization initiator into the polymerization solvent together with the monomers. This makes it easier to control the polymerization reaction. Further, it is preferable to drop the polymerization initiator after the monomers have been dropped into the polymerization solvent. This makes it possible to reduce the amount of residual monomers. In this case, the period during which the monomers are dropped into the polymerization solvent and the period during which the polymerization initiator is dropped into the polymerization solvent may not overlap, or at least part of the period during which the monomers are dropped into the polymerization solvent may overlap with the period during which the polymerization initiator is dropped into the polymerization solvent.

The optimum polymerization temperature range depends on factors such as the kind of polymerization solvent. The polymerization temperature may be, for example, a temperature within the range of 50°C or higher and 110°C or lower. The optimum polymerization time range depends on the kind of polymerization initiator, polymerization temperature, and the like. For example, when 1,1,3,3-tetramethylbutylperoxy-2-ethylhexanoate is used as the polymerization initiator and the polymerization temperature is set to 95°C, the polymerization time is preferably about 6 hours.

Note that the copolymer may be used for the production of a colored resin composition without performing any treatment other than the polymerization reaction on the reaction solution containing the copolymer obtained by the polymerization reaction. Alternatively, the copolymer may be isolated from the reaction solution after the polymerization reaction. Filtration, purification, or the like can be used to isolate the copolymer.

The percentage (100 × WM/W(M + P)) of the weight (WM) of the acrylic monomer with respect to the sum (W(M + P)) of the weight of the copolymer and the weight of the monomers constituting the copolymer is preferably 20% or lower. The monomers constituting the copolymer are monomers corresponding to the repeating units constituting the copolymer. The copolymer includes the first, second, and third repeating units. Therefore, the monomers corresponding to the unit structures constituting the copolymer include at least one of the first monomer for forming the first repeating unit, the second monomer for forming the second repeating unit, and the third monomer for forming the third repeating unit. That is, the percentage (100 × WM/W(M + P)) of the weight (WM) of the monomers with respect to the sum (W(M + P)) of the weight of the copolymer and the weight of the monomers that were prepared to produce the copolymer but were not used to produce the copolymer is preferably 20% or lower. Compared to the case where there is more than 20% of residual monomer, the absorbance of the cured film formed using the colored resin composition of the present disclosure is less likely to change.

The percentage (100 × WM/W(M + P)) of the weight (WM) of the monomers constituting the copolymer with respect to the sum (W(M + P)) of the weight of the copolymer and the weight of the monomers is more preferably 10% or lower, and even more preferably 3% or lower. The weight of the copolymer and the weight of the monomers can be quantified based on analytical results of the copolymer. The method of analyzing the copolymer may be, for example, gas chromatography-mass spectrometry (GC-MS), nuclear magnetic resonance spectroscopy (NMR), or infrared spectroscopy (IR).

The ratio of the weight (WM) of the monomers to the sum (W(M + P)) of the weight of the copolymer and the weight of the monomers may be changed by, for example, changing the polymerization time or the polymerization temperature. The ratio of the weight (WM) of the monomers to the sum (W(M + P)) of the weight of the copolymer and the weight of the monomers may also be changed by changing the concentrations of the monomers and the radical polymerization initiator at the start of the polymerization reaction. The ratio of the weight (WM) of the monomers to the sum (W(M + P)) of the weight of the copolymer and the weight of the monomers may be changed by changing the conditions of purification carried out after the polymerization reaction. Among these examples, changing the polymerization time is preferable because the change in the weight ratio of the monomers can be accurately controlled.

[Method of manufacturing colored resin composition]

A colored resin composition can be manufactured by mixing the colorant, copolymer, and solvent described above using a mixing device. Note that the method of manufacturing a colored resin composition may include a step of filtering the mixed solution after the step of mixing the colorant, the copolymer, and the solvent to generate the mixed solution. According to the step of filtering the mixture, it is possible to remove substances such as foreign substances and insoluble substances in the environment from the colored resin composition. A filter may be used for the filtration of the mixture.

[Method of evaluating colored resin composition]

The absorbance of the cured film formed from the colored resin composition of the present disclosure is evaluated as follows. First, a coating film is formed by coating a transparent material with the colored resin composition. Then, the coating film is heated so as to volatilize the solvent contained in the coating film and form a cured film. The infrared absorbance of the formed cured film is evaluated. Although the film thickness of the cured film is not particularly limited, it is preferably within the range of 1 μm or greater and 100 μm or smaller, for example.

To calculate the absorbance of the cured film, the transmittance spectrum of the cured film is measured. In the measurement of the transmittance spectrum, the transmittance spectrum of the cured film is measured using a spectrophotometer capable of measuring the transmittance of the cured film from the ultraviolet wavelength band to the infrared wavelength band. The absorbance of the cured film is calculated by converting the measured transmittance into absorbance. The absorbance Aλ at a certain wavelength λ is calculated using the following equation.

$$A\lambda = -\log_{10}(\%T/100)$$

In the above equation, the transmittance T is expressed by the ratio (TL/IL) of the intensity of the transmitted light (TL) to the intensity of the incident light (IL) when infrared light is transmitted through the cured film of the colored resin composition. That is, the intensity of the transmitted light when the intensity of the incident light is assumed to be one is the transmittance T of the cured film. The value obtained by multiplying the transmittance T by 100 is the transmittance percent %T.

[Optical filter]

The colored resin composition of the present disclosure is used to manufacture an optical filter. The optical filter may be used as a single layer filter, that is, without layers other than the optical filter. Alternatively, the optical filter may be included in a laminate including the optical filter and one or more other layers in contact with the optical filter. The other layer may be, for example, a color filter.

The method for manufacturing the optical filter includes applying a coating solution prepared using a colored resin composition including a colorant, a copolymer, and a solvent to a substrate, and curing the coating solution. The substrate may be, for example, a transparent resin plate, a transparent film, a transparent glass plate, or an image sensor. The application of the colored resin composition may be carried out using, for example, a spin coater, bar coater, roll coater, gravure coater, offset coater, or spray.

By heating the coating film formed by applying the colored resin composition, the solvent is removed from the colored resin composition, and a cured film is formed. The optical filter can thus be obtained. A hot plate, an oven, or the like can be used to heat the coating film. If necessary, after forming the cured film, it is also possible to form an optical filter having a predetermined pattern by subjecting the cured film to processing using photolithography and dry etching.

Note that, as described above, it is preferable to use a colored resin composition in which the percentage of

the weight of the colorant to the weight of the solvent is 0.6% by weight or more and 30% by weight or less for the formation of the optical filter. In addition, it is preferable to use a colored resin composition including a colorant having a molar absorption coefficient ε of $3.0\times10^4$ or higher at the maximum absorbance wavelength for the formation of the optical filter.

The optical filter of the present disclosure can suppress the transmission of near-infrared light to the side of the optical filter opposite to the light incident side. That is, the optical filter absorbs the light incident thereon and prevents the light incident on the optical filter from passing through the optical filter. Therefore, for example, it is possible to apply the optical filter to a heat insulating film. As another example, the optical filter can be applied to an optical product, which may be, for example, an image sensor or a display. As yet another example, it is possible to apply the optical filter to a member forming sunglasses.

[Production Example]

[Production Example 1]

Polymer production examples will be described with reference to Table 1. Note that, when the polymer is a copolymer prepared using two or more monomers, the weight ratio of the repeating units in the prepared copolymer is the same as the weight ratio of the monomers when the copolymer is formed.

[Table 1]

| Production Ex. | 1st repeating unit | | 2nd repeating unit | | 3rd repeating unit | |
|---|---|---|---|---|---|---|
| | Monomer name | Parts by wt. | Monomer name | Parts by wt. | Monomer name | Parts by wt. |
| 1-1 | Glycidyl methacrylate | 15 | 4-hydroxyphenyl (meth)acrylate | 15 | Phenyl (meth)acrylate | 70 |
| 1-2 | Glycidyl methacrylate | 15 | N-hydroxyphenylmaleimide | 15 | Phenyl (meth)acrylate | 70 |
| 1-3 | Glycidyl methacrylate | 15 | 4-hydroxyphenyl (meth)acrylate | 15 | Dicyclopentenyl (meth) acrylate | 70 |
| 1-4 | - | - | - | - | Phenyl (meth)acrylate | 100 |
| 1-5 | - | - | 4-hydroxyphenyl (meth)acrylate | 30 | Phenyl (meth)acrylate | 70 |
| 1-6 | - | - | - | - | Methyl (meth)acrylate | 100 |

[Production Example 1-1]

Propylene glycol monomethyl ether acetate (120.0 g) was added into a 1 L separable flask provided with a stirrer, thermometer, condenser, dropping funnel, and nitrogen introduction tube. The air inside of the flask was replaced with nitrogen to create a nitrogen atmosphere in the flask. A monomer solution was prepared by mixing glycidyl methacrylate (24.0 g), 4-hydroxyphenyl methacrylate (24.0 g), phenyl methacrylate (112.0 g), and propylene glycol monomethyl ether acetate (20.0 g), and a polymerization initiator solution was prepared by mixing propylene glycol monomethyl ether acetate (20.0 g) and 1,1,3,3-tetramethylbutylperoxy-2-ethylhexanoate (PEROCTA O, manufactured by NOF Corporation) (PEROCTA is a registered trademark) (3.2 g).

The inside of the flask was heated to 95°C, and the monomer solution and the polymerization initiator solution were simultaneously added dropwise over 3 hours. After that, the mixture of the monomer solution and the polymerization initiator solution was reacted at 95°C for 2 hours, and then 1,1,3,3-tetramethylbutylperoxy-2-ethylhexanoate (0.6 g) was added. After further reacting the mixed solution together with the added polymerization initiator at 95°C for 3 hours, the solution was diluted with propylene glycol monomethyl ether acetate so that the polymer concentration became 20% by weight, and a 20% by weight polymer solution was obtained. The weight average molecular weight of the copolymer was found to be 78,300 and the residual monomer content (100 × WM/W(M+P)) in the 20% by weight polymer solution was found to be 1.6%.

[Production Example 1-2]

A 20% by weight polymer solution of the copolymer of Production Example 1-2 was prepared in the same manner as in Production Example 1-1, except that 4-hydroxyphenyl methacrylate in Production Example 1-1 was changed to N-hydroxyphenylmaleimide. The weight average molecular weight of the copolymer was found to be 51,200 and the residual monomer content in the 20% by weight polymer solution was found to be 2.9%.

[Production Example 1-3]

A 20% by weight polymer solution of the copolymer of Production Example 1-3 was prepared in the same manner as in Production Example 1-1, except that phenyl methacrylate in Production Example 1-1 was changed to dicyclopentanyl methacrylate. The weight average molecular weight of the copolymer was found to be 67,900, and the residual monomer content in the 20% by weight polymer solution was found to be 2.1%.

[Production Example 1-4]

A 20% by weight polymer solution of the copolymer of Production Example 1-4 was prepared in the same manner as in Production Example 1-1, except that the monomer solution in Production Example 1-1 was changed to a mixed solution of phenyl methacrylate (160.0 g) and propylene glycol monomethyl ether acetate (20.0 g). The weight average molecular weight of the polymer was found to be 57,700, and the residual monomer content in the 20% by weight polymer solution was found to be 1.9%.

[Production Example 1-5]

A 20% by weight polymer solution of the copolymer of Production Example 1-5 was prepared in the same manner as in Production Example 1-1, except that the monomer solution in Production Example 1-1 was changed to a mixed solution of 4-hydroxyphenyl methacrylate (48.0 g), phenyl methacrylate (112.0 g), and propylene glycol monomethyl ether acetate (20.0 g). The weight average molecular weight of the copolymer was found to be 88,000, and the residual monomer content in the 20% by weight polymer solution was found to be 2.1%.

[Production Example 1-6]

A 20% by weight polymer solution of the copolymer of Production Example 1-6 was prepared in the same manner as in Production Example 1-1, except that the monomer solution in Production Example 1-1 was changed to a mixed solution of methyl methacrylate (160.0 g) and propylene glycol monomethyl ether acetate (20.0 g). The weight average molecular weight of the polymer was found to be 51,000, and the residual monomer content in the 20% by weight polymer solution was found to be 2.1%.

For each production example, the weight average molecular weight and residual monomer content were obtained as follows.

[Weight average molecular weight]

The weight average molecular weight (Mw) of the 20% by weight polymer solution of each production example was determined using gel permeation chromatography (GPC) under the following conditions.

Device: HLC-8220 manufactured by Tosoh Corporation
Column: LF-804 manufactured by Shodex
Reference material: Polystyrene
Eluent: Tetrahydrofuran (THF)
Flow rate: 1.0 ml/min
Column temperature: 40°C
Detector: Differential refractive index detector (RI)

[Residual monomer content]

For the 20% by weight polymer solution of each production example, the content of each monomer in the polymer solution was measured according to the internal standard method using gas chromatography (GC). Then, the

total monomer amount (WM) was calculated by adding up the content of each monomer. The total amount of input monomers (W(M+P)) was calculated by adding up the amount of each monomer input during synthesis. Based on these, the residual monomer amount (100 × WM/W(M + P)) in each production example was calculated. The measurement conditions for gas chromatography were set as follows.

Device: GC-2014 manufactured by Shimadzu Corporation
Column: DB-1 manufactured by Agilent Technologies
Injection temperature: 300°C
Detector temperature: 300°C
Heating profile: Raised from 40°C to 300°C at 20°C/min and maintained for 4 minutes
Injection amount: 2 μL
Detector: FID
Carrier gas: Helium 70 kPa
Split ratio: 1/30

After adding biphenyl (0.01 g) and acetone (2 g) as internal standards to the 20% by weight polymer solution (3.0 g) of each production example and mixing them, methanol (25 g) was added and mixed, to cause the polymer to precipitate. The supernatant was filtered and subjected to GC measurement.

[Production Example 2]

Copolymer production examples will be described with reference to Table 2. The weight average molecular weight and the amount of residual monomers in each of the production examples described below were determined in the same manner as in Production Example 1 described above.

[Table 2]

| Production Ex. | 1st repeating unit | 2nd repeating unit | 3rd repeating unit |
|---|---|---|---|
| | Glycidyl methacrylate | 4-hydroxyphenyl (meth)acrylate | Phenyl (meth)acrylate |
| | Parts by wt. | Parts by wt. | Parts by wt. |
| 2-1 | 20 | 10 | 70 |
| 2-2 | 15 | 15 | 70 |
| 2-3 | 10 | 20 | 70 |
| 2-4 | 7.5 | 22.5 | 70 |
| 2-5 | 6 | 24 | 70 |
| 2-6 | 5 | 25 | 70 |
| 2-7 | 17.5 | 17.5 | 65 |
| 2-8 | 11.5 | 23.5 | 65 |
| 2-9 | 10 | 25 | 65 |
| 2-10 | 20 | 20 | 60 |
| 2-11 | 25 | 25 | 50 |

[Production Example 2-1]

A 20% by weight polymer solution of the copolymer of Production Example 2-1 was prepared in the same manner as in Production Example 1-1, except that the monomer solution in Production Example 1-1 was changed to a mixed solution of glycidyl methacrylate (32.0 g), 4-hydroxyphenyl methacrylate (16.0 g), phenyl methacrylate (112.0 g), and propylene glycol monomethyl ether acetate (20.0 g). The weight average molecular weight of the copolymer was found to be 67,100, and the residual monomer content in the 20% by weight polymer solution was found to be 1.7%.

[Production Example 2-2]

A 20% by weight polymer solution of Production Example 2-2 was obtained in the same manner as in Production Example 1-1. The weight average molecular weight of the copolymer was found to be 78,100, and the residual monomer content in the 20% by weight polymer solution was found to be 1.7%.

[Production Example 2-3]

A 20% by weight polymer solution of the copolymer of Production Example 2-3 was prepared in the same manner as in Production Example 1-1, except that the monomer solution in Production Example 1-1 was changed to a mixed solution of glycidyl methacrylate (16.0 g), 4-hydroxyphenyl methacrylate (32.0 g), phenyl methacrylate (112.0 g), and propylene glycol monomethyl ether acetate (20.0 g). The weight average molecular weight of the copolymer was found to be 82,000, and the residual monomer content in the 20% by weight polymer solution was found to be 1.7%.

[Production Example 2-4]

A 20% by weight polymer solution of the copolymer of Production Example 2-4 was prepared in the same manner as in Production Example 1-1, except that the monomer solution in Production Example 1-1 was changed to a mixed solution of glycidyl methacrylate (12.0 g), 4-hydroxyphenyl methacrylate (36.0 g), phenyl methacrylate (112.0 g), and propylene glycol monomethyl ether acetate (20.0 g). The weight average molecular weight of the copolymer was found to be 83,800, and the residual monomer content in the 20% by weight polymer solution was found to be 1.6%.

[Production Example 2-5]

A 20% by weight polymer solution of the copolymer of Production Example 2-5 was prepared in the same manner as in Production Example 1-1, except that the monomer solution in Production Example 1-1 was changed to a mixed solution of glycidyl methacrylate (9.6 g), 4-hydroxyphenyl methacrylate (38.4 g), phenyl methacrylate (112.0 g), and propylene glycol monomethyl ether acetate (20.0 g). The weight average molecular weight of the copolymer was found to be 85,300, and the residual monomer content in the 20% by weight polymer solution was found to be 1.7%.

[Production Example 2-6]

A 20% by weight polymer solution of the copolymer of Production Example 2-6 was prepared in the same manner as in Production Example 1-1, except that the monomer solution in Production Example 1-1 was changed to a mixed solution of glycidyl methacrylate (8.0 g), 4-hydroxyphenyl methacrylate (40.0 g), phenyl methacrylate (112.0 g), and propylene glycol monomethyl ether acetate (20.0 g). The weight average molecular weight of the copolymer was found to be 85,500, and the residual monomer content in the 20% by weight polymer solution was found to be 1.6%.

[Production Example 2-7]

A 20% by weight polymer solution of the copolymer of Production Example 2-7 was prepared in the same manner as in Production Example 1-1, except that the monomer solution in Production Example 1-1 was changed to a mixed solution of glycidyl methacrylate (28.0 g), 4-hydroxyphenyl methacrylate (28.0 g), phenyl methacrylate (104.0 g), and propylene glycol monomethyl ether acetate (20.0 g). The weight average molecular weight of the copolymer was found to be 76,900, and the residual monomer content in the 20% by weight polymer solution was found to be 1.7%.

[Production Example 2-8]

A 20% by weight polymer solution of the copolymer of Production Example 2-8 was prepared in the same manner as in Production Example 1-1, except that the monomer solution in Production Example 1-1 was changed to a mixed solution of glycidyl methacrylate (18.4 g), 4-hydroxyphenyl methacrylate (37.6 g), phenyl methacrylate (104.0 g), and propylene glycol monomethyl ether acetate (20.0 g). The weight average molecular weight of the copolymer was found to be 84,000, and the residual monomer content in the 20% by weight polymer solution was found to be 1.9%.

[Production Example 2-9]

A 20% by weight polymer solution of the copolymer of Production Example 2-9 was prepared in the same manner as in Production Example 1-1, except that the monomer solution in Production Example 1-1 was changed to a

mixed solution of glycidyl methacrylate (16.0 g), 4-hydroxyphenyl methacrylate (40.0 g), phenyl methacrylate (104.0 g), and propylene glycol monomethyl ether acetate (20.0 g). The weight average molecular weight of the copolymer was found to be 89,300, and the residual monomer content in the 20% by weight polymer solution was found to be 1.5%.

[Production Example 2-10]

A 20% by weight polymer solution of the copolymer of Production Example 2-10 was prepared in the same manner as in Production Example 1-1, except that the monomer solution in Production Example 1-1 was changed to a mixed solution of glycidyl methacrylate (32.0 g), 4-hydroxyphenyl methacrylate (32.0 g), phenyl methacrylate (96.0 g), and propylene glycol monomethyl ether acetate (20.0 g). The weight average molecular weight of the copolymer was found to be 90,400, and the residual monomer content in the 20% by weight polymer solution was found to be 1.6%.

[Production Example 2-11]

A 20% by weight polymer solution of the copolymer of Production Example 2-11 was prepared in the same manner as in Production Example 1-1, except that the monomer solution in Production Example 1-1 was changed to a mixed solution of glycidyl methacrylate (40.0 g), 4-hydroxyphenyl methacrylate (40.0 g), phenyl methacrylate (80.0 g), and propylene glycol monomethyl ether acetate (20.0 g). The weight average molecular weight of the copolymer was found to be 92,600, and the residual monomer content in the 20% by weight polymer solution was found to be 1.5%.

[Test Examples]

[Test Example 1]

In Test Example 1, six kinds of colored resin compositions were obtained by using the copolymers of Production Examples 1-1 to 1-6 as follows. Further, a cured film was formed from each colored resin composition. The light absorbance of each cured filter was calculated as described below before the tests, after the solvent resistance test, and after the heat resistance test. When forming the cured film of each test example, a cured film used for the solvent resistance test described below and a cured film used for the heat resistance test were separately formed.

A coating solution containing a cyanine dye (0.3 g), 20% by weight polymer solution (15.0 g), and propylene glycol monomethyl ether acetate (10 g) was prepared. A dye represented by the above formula (6) was used as the cyanine dye, and six kinds of polymer solutions respectively containing the polymers or copolymers obtained in Production Examples 1-1 to 1-6 were used. The coating solution was applied onto a transparent substrate and the coating film was dried. Then, the coating film was cured by heating it at 230°C for 10 minutes, and the cured films of Test Examples 1-1 to 1-6 each having a thickness of 1.0 μm were obtained.

[Evaluation Method]

[Spectral Characteristic]

Using a spectrophotometer (U-4100 manufactured by Hitachi High-Technologies Corporation), the transmittance of the cured film of each test example to light having wavelengths from 350 nm to 1150 nm was measured. Then, the absorbance was calculated from the measured transmittance results. An absorbance spectrum was thus obtained for each cured film. The absorbance spectrum of a cyanine dye represented by the above formula (6) has a peak at 950 nm. Therefore, whether the absorbance at 950 nm is 0.8 or higher was checked for each cured film. When the absorbance is 0.8 or higher, it corresponds to the cyanine dye in the cured film absorbing 85% or more of light having a wavelength of 950 nm. Therefore, it can be said that the cured film sufficiently serves as an optical filter absorbing light at a wavelength of 950 nm.

[Solvent resistance]

After measuring the transmittance of the cured film of each test example, the cured film was immersed in N-methylpyrrolidone, which is an example of a solvent, for a minute. The transmittance of the cured film of each test example after the immersion was measured in the same way the transmittance of the cured film of each test example was measured before the immersion. Then, the absorbance was calculated from the measured transmittance results. An absorbance spectrum was thus obtained for each of the cured films of the test examples after the immersion. Whether the absorbance of the cured film of each test example after the immersion was 0.7 or higher at 950 nm was checked. When the absorbance of the cured film after immersion is 0.7 or higher, and the cured film before immersion shows

enough absorbance to serve as an optical filter, it can be said that the change in absorbance after immersion is small.

[Heat resistance]

After measuring the transmittance of the cured film of each test example, the cured film of each test example was heated at 250°C for 5 minutes. The transmittance of the cured film of each test example after the heating was measured in the same way the transmittance of the cured film of each test example was measured before the heating. Then, the absorbance was calculated from the measured transmittance results. An absorbance spectrum was thus obtained for each of the cured films of the test examples after the heating. Whether the absorbance of the cured film of each test example after the heating was 0.7 or higher at 950 nm was checked. When the absorbance of the cured film after heating is 0.7 or higher, and the cured film before heating shows enough absorbance to serve as an optical filter, it can be said that the change in absorbance after heating is small.

[Evaluation results]

The calculated absorbances of the cured films of Test Examples 1-1 to 1-6 were as shown in Table 3 below. Note that, for each test example, it was confirmed that the absorbance of the cured film prepared for the solvent resistance test before conducting the test is the same as the absorbance of the cured film prepared for the heat resistance test before conducting the test.

[Table 3]

| Test Ex. | Before test | After solvent resistance test | After heat resistance test |
|---|---|---|---|
| 1-1 | 0.96 | 0.85 | 0.80 |
| 1-2 | 0.96 | 0.85 | 0.82 |
| 1-3 | 0.96 | 0.72 | 0.72 |
| 1-4 | 0.96 | 0.05 | 0.52 |
| 1-5 | 0.96 | 0.05 | 0.74 |
| 1-6 | 0.50 | 0.05 | 0.15 |

As shown in Table 3, the absorbance of Test Examples 1-1 to 1-5 before the resistance tests was 0.96, and it was found that the cured films of Test Examples 1-1 to 1-5 had an absorbance of 0.8 or greater. On the other hand, the absorbance of Test Example 1-6 before the resistance tests was 0.50, and it was found that the cured film of Test Example 1-6 had an absorbance lower than 0.8. After the solvent resistance test, it was found that the cured film of Test Example 1-1 and the cured film of Test Example 1-2 had an absorbance of 0.85. The absorbance of the cured film of Test Examples 1-3 was 0.72. Meanwhile, the absorbances of the cured film of Test Example 1-4, the cured film of Test Example 1-5, and the cured film of Test Example 1-6 were 0.05.

From the comparison between the absorbances of Test Examples 1-1 to 1-3 and the absorbances of Test Examples 1-4 to 1-6, it can be said that the solvent resistance of the cured film is enhanced when the first repeating unit in the copolymer has an epoxy group and the second repeating unit has a phenolic hydroxyl group.

Further, as shown in Fig. 3, after the heat resistance test, the cured film of Test Example 1-1 had an absorbance of 0.80, and the cured film of Test Example 1-2 had an absorbance of 0.82. The cured film of Test Example 1-3 had an absorbance of 0.72, and the cured film of Test Example 1-4 had an absorbance of 0.52. The cured film of Test Example 1-5 had an absorbance of 0.74, and the cured film of Test Example 1-6 had an absorbance of 0.15.

It can be seen that the cured films of Test Examples 1-1 to 1-3 and Test Examples 1-5 had only a small change in absorbance after the heat resistance test. On the other hand, it was found that the cured film of Test Example 1-4 had a large change in absorbance after the heat resistance test. That is, from the comparison between the cured films of Test Examples 1-1 to 1-3 and the cured film of Test Example 1-4, it can be said that the heat resistance of the cured film is enhanced when the first repeating unit in the copolymer has an epoxy group and the second repeating unit has a phenolic hydroxyl group.

According to the copolymers having the first repeating unit with an epoxy group and the second repeating unit with a phenolic hydroxyl group, it can be said that the cured film has both good solvent resistance and heat resistance.

Further, by comparing the cured film of Test Example 1-4 and the cured film of Test Example 1-6, it can be said that it is possible to prevent the spectral characteristics of the cured film at the wavelengths at which the dye is expected to absorb light from deteriorating when the third repeating unit in the cured film before the resistance tests has

an aromatic ring.

[Test Example 2]

In Test Example 2, 11 kinds of cured films were obtained by using the copolymers of Production Examples 2-1 to 2-11 as follows. The light absorbance of each cured film was calculated as described above before the tests, after the solvent resistance test, and after the heat resistance test. When producing the cured film of each test example, a cured film used for the solvent resistance test and a cured film used for the heat resistance test were separately produced.

A coating solution containing a cyanine dye (0.3 g), 20% by mass polymer solution (15.0 g), and propylene glycol monomethyl ether acetate (10 g) was prepared. A dye represented by the above formula (6) was used as the cyanine dye, and 11 kinds of polymer solutions respectively containing the copolymers obtained in Production Examples 2-1 to 2-11 were used. The coating solution was applied onto a transparent substrate and the coating film was dried. Then, the coating film was cured by heating it at 230°C for 10 minutes, and the cured films of Test Examples 2-1 to 2-11 each having a thickness of 1.0 μm were obtained.

[Evaluation Method]

The absorbance spectra of the cured films of Test Examples 2-1 to 2-11 were obtained in the same manner as in Test Example 1. Further, the cured films of Test Examples 2-1 to 2-11 were subjected to the solvent resistance test and heat resistance test in the same manner as in Test Example 1. An absorbance spectrum was obtained for each of the cured films of the test examples after each test as in Test Example 1.

[Evaluation results]

The calculated absorbances of the cured films of Test Examples 2-1 to 2-11 were as shown in Table 4 below. Note that, for each test example, it was confirmed that the absorbance of the cured film prepared for the solvent resistance test before conducting the test is the same as the absorbance of the cured film prepared for the heat resistance test before conducting the test.

[Table 4]

| Test Ex. | Before test | After solvent resistance test | After heat resistance test |
|---|---|---|---|
| 2-1 | 0.96 | 0.02 | 0.80 |
| 2-2 | 0.96 | 0.85 | 0.80 |
| 2-3 | 0.96 | 0.82 | 0.82 |
| 2-4 | 0.96 | 0.72 | 0.80 |
| 2-5 | 0.96 | 0.30 | 0.80 |
| 2-6 | 0.96 | 0.05 | 0.82 |
| 2-7 | 0.96 | 0.85 | 0.72 |
| 2-8 | 0.96 | 0.80 | 0.80 |
| 2-9 | 0.96 | 0.72 | 0.80 |
| 2-10 | 0.68 | 0.64 | 0.40 |
| 2-11 | 0.59 | 0.55 | 0.21 |

As shown in Table 4, the absorbances of the cured films of Test Examples 2-1 to 2-9 before the resistance test were 0.96. On the other hand, the absorbance of the cured film of Test Example 2-10 before the resistance test was 0.68, and the absorbance of the cured film of Test Example 2-11 before the resistance test was 0.59.

Therefore, the cured films of Test Examples 2-1 to 2-9 before the resistance test had an absorbance of 0.8 or greater at 950 nm. whereas those of Test Examples 2-10 and 2-11 before the resistance test had an absorbances below 0.8 at 950 nm. A comparison of the cured films of Test Examples 2-1 to 2-9 and the cured films of Test Examples 2-10 and 2-11 shows that the spectral characteristics of the cured film before the test were maintained when the proportion of the third repeating unit in the copolymer was 65% by weight or more.

Further, after the solvent resistance test, the cured film of Test Example 2-1 had an absorbance of 0.02, the

cured film of Test Example 2-2 had an absorbance of 0.85, and the cured film of Test Example 2-3 had an absorbance of 0.82. The cured film of Test Example 2-4 had an absorbance of 0.72, the cured film of Test Example 2-5 had an absorbance of 0.30, and the cured film of Test Example 2-6 had an absorbance of 0.05. The cured film of Test Example 2-7 had an absorbance of 0.85, the cured film of Test Example 2-8 had an absorbance of 0.80, and the cured film of Test Example 2-9 had an absorbance of 0.72. The cured film of Test Example 2-10 had an absorbance of 0.64, and the cured film of Test Example 2-11 had an absorbance of 0.55.

Therefore, the cured films of Test Examples 2-2 to 2-4 and 2-7 to 2-9 after the solvent resistance test had absorbances of 0.7 or greater at 950 nm. On the other hand, Test Examples 2-1, 2-5, 2-6, 2-10, and 2-11 after the solvent resistance test had absorbances below 0.7.

The comparison of the cured films of Test Examples 2-1 to 2-9 indicates that cured films can have an improved solvent resistance when the proportion of the first repeating unit in the copolymer is in the range of 7.5% by weight or higher and 17.5% by weight or lower, and the ratio by weight of the second repeating unit to the first repeating unit is in the range of 1.0 or higher and 3.0 or lower.

Further, as shown in Table 4, after the heat resistance test, the cured film of Test Example 2-1 and the cured film of Test Example 2-2 had an absorbance of 0.80, and the cured film of Test Example 2-3 had an absorbance of 0.82. The cured film of Test Example 2-4 and the cured film of Test Example 2-5 had an absorbance of 0.80, and the cured film of Test Example 2-6 had an absorbance of 0.82. The cured film of Test Example 2-7 had an absorbance of 0.72, and the cured film of Test Example 2-8 and the cured film of Test Example 2-9 had an absorbance of 0.80. The cured film of Test Example 2-10 had an absorbance of 0.40, and the cured film of Test Example 2-11 had an absorbance of 0.21.

Therefore, the cured films of Test Examples 2-1 to 2-9 after the heat resistance test all had absorbances of 0.7 or more at 950 nm. That is, it was confirmed that the heat resistance of the cured film can be maintained even when the ratio of the weight of the second repeating unit to the weight of the first repeating unit is changed in the range of 0.5 or higher and 5.0 or lower. The amount of change in absorbance in the cured films of Test Examples 2-10 and 2-11 was 0.28 or greater, which was greater than the amount of change in absorbance in the cured films of Test Examples 2-1 to 2-9. Therefore, it was found that when the proportion of the third repeating unit in the copolymer is less than 65% by weight, the heat resistance also decreases.

Note that the evaluation results of the cured films of Test Examples 2-1 to 2-11 indicate that, when the proportion of the third repeating unit is 65% by weight or higher, the ratio of the weight of the second repeating unit to the weight of the third repeating unit can be in the range of 1.0 or higher and 3.0 or lower if the goal is to achieve both the solvent resistance and heat resistance of the cured film.

[Test Example 3]

With reference to Table 5, Test Example 3 will be described.

[Test Example 3-1]

A coating solution containing a cyanine dye (0.05 g), 20% by weight polymer solution (15 g), and propylene glycol monomethyl ether acetate (10 g) was prepared. That is, the percentage of colorant weight to solvent weight was set to 0.23% by weight. It was confirmed that the colorant was dissolved in the solvent of the coating solution. A dye represented by the above formula (6) was used as the cyanine dye, and a polymer solution containing the copolymer obtained in the above described Production Example 1-1 was used. The coating solution was applied onto a transparent substrate and the coating film was dried. Then, the coating film was cured by heating it at 230°C for 10 minutes, and the cured film of Test Example 3-1 having a thickness of 1.0 μm was obtained.

[Test Example 3-2]

In Test Example 3-1, the amount of cyanine dye was changed from 0.05 g to 0.1 g. That is, the percentage of colorant weight to solvent weight was set to 0.45% by weight. It was confirmed that the colorant was dissolved in the solvent of the coating solution. Except for the above, the cured film of Test Example 3-2 was obtained in the same manner as in Test Example 3-1.

[Test Example 3-3]

In Test Example 3-1, the amount of cyanine dye was changed from 0.05 g to 0.2 g. That is, the percentage of colorant weight to solvent weight was set to 0.91% by weight. It was confirmed that the colorant was dissolved in the solvent of the coating solution. Except for the above, the cured film of Test Example 3-3 was obtained in the same manner as in Test Example 3-1.

[Test Example 3-4]

In Test Example 3-1, the amount of cyanine dye was changed from 0.05 g to 0.3 g. That is, the percentage of colorant weight to solvent weight was set to 1.4% by weight. It was confirmed that the colorant was dissolved in the solvent of the coating solution. Except for the above, the cured film of Test Example 3-4 was obtained in the same manner as in Test Example 3-1.

[Test Example 3-5]

In Test Example 3-1, the amount of cyanine dye was changed from 0.05 g to 1.0 g. That is, the percentage of colorant weight to solvent weight was set to 4.5% by weight. It was confirmed that the colorant was dissolved in the solvent of the coating solution. Except for the above, the cured film of Test Example 3-5 was obtained in the same manner as in Test Example 3-1.

[Test Example 3-6]

In Test Example 3-1, the amount of cyanine dye was changed from 0.05 g to 4.0 g. That is, the percentage of colorant weight to solvent weight was set to 18.2% by weight. It was confirmed that the colorant was dissolved in the solvent of the coating solution. Except for the above, the cured film of Test Example 3-6 was obtained in the same manner as in Test Example 3-1.

[Test Example 3-7]

In Test Example 3-1, the amount of cyanine dye was changed from 0.05 g to 7 g. That is, the percentage of colorant weight to solvent mass was set to 31.8% by weight. It was confirmed that the colorant was dissolved in the solvent of the coating solution. Except for the above, the cured film of Test Example 3-7 was obtained in the same manner as in Test Example 3-1.

[Test Example 3-8]

In Test Example 3-1, the amount of cyanine dye was changed from 0.05 g to 8 g. That is, the percentage of colorant weight to solvent mass was set to 36.4% by weight. It was confirmed that the colorant was dissolved in the solvent of the coating solution. Except for the above, the cured film of Test Example 3-8 was obtained in the same manner as in Test Example 3-1.

[Evaluation Method]

The absorbance spectra of the cured films of Test Examples 3-1 to 3-8 were obtained in the same manner as in Test Example 1.

[Evaluation results]

The calculated absorbances of the cured films of Test Examples 3-1 to 3-8 were as shown in Table 5 below. Table 5 shows the absorbance at 950 nm at which the cyanine dye exhibits the maximum absorbance.

[Table 5]

| Test Ex. | (WC/WS) × 100 | Absorbance |
|---|---|---|
| 3-1 | 0.23 | 0.1 |
| 3-2 | 0.45 | 0.4 |
| 3-3 | 0.91 | 0.8 |
| 3-4 | 1.4 | 0.96 |
| 3-5 | 4.5 | 1.5 |
| 3-6 | 18.2 | 2.5 |
| 3-7 | 31.8 | 0.5 |

(continued)

| Test Ex. | (WC/WS) × 100 | Absorbance |
|---|---|---|
| 3-8 | 36.4 | 0.5 |

As shown in Table 5, the cured film of Test Example 3-1 had an absorbance of 0.1, and the cured film of Test Example 3-2 had an absorbance of 0.4. The cured film of Test Example 3-3 had an absorbance of 0.8, the cured film of Test Example 3-4 had an absorbance of 0.96, and the cured film of Test Example 3-5 had an absorbance of 1.5. The cured film of Test Example 3-6 had an absorbance of 2.5, the cured film of Test Example 3-7 had an absorbance of 0.5, and the cured film of Test Example 3-8 had an absorbance of 0.5. In addition, a large number of precipitate clusters of the colorant were observed on the surface of the cured films of Test Examples 3-7 and 3-8. In Test Examples 3-7 and 3-8, it can be said that the absorbance of the cured film deteriorated due to such clusters of colorant.

Thus, it was found that, when the percentage of the weight of the colorant (WC) to the weight of the solvent (WS) is 0.6% by weight or more and 30% by weight or less, a cured film having a thickness of 1.0 μm can exhibit sufficient absorbance as an optical filter. The solvent weight (WS) shown in Table 5 is the sum of the weight of the solvent used to prepare the coating solution and the weight of the solvent contained in the polymer solution.

[Test Example 4]

With reference to Table 6, Test Example 4 will be described.

[Test Example 4-1]

A coating solution containing a diimmonium dye (0.3 g, Dye 1500, manufactured by ORGNICA), 20% by weight polymer solution (15 g), and propylene glycol monomethyl ether acetate (10 g) was prepared. The molar absorption coefficient of the diimmonium dye is $2.2 \times 10^4$, and the diimonium dye has a maximum absorbance at 960 nm. A polymer solution containing the copolymer obtained in Production Example 1-1 described above was used. The coating solution was applied onto a transparent substrate and the coating film was dried. Then, the coating film was cured by heating it at 150°C for 10 minutes, and the cured film of Test Example 4-1 having a thickness of 1.0 μm was obtained.

[Test Example 4-2]

In Test Example 4-1, the amount of diimmonium dye was changed to 1.0 g. Except for the above, the cured film of Test Example 4-2 was obtained in the same manner as in Test Example 4-1.

[Test Example 4-3]

In Test Example 4-1, the amount of diimmonium dye was changed to 1.5 g. Except for the above, the cured film of Test Example 4-3 was obtained in the same manner as in Test Example 4-1.

[Test Example 4-4]

In Test Example 4-1, the diimonium dye was changed to a bisdithiobenzylnickel dye (B1350, manufactured by Tokyo Chemical Industry Co., Ltd.), and propylene glycol monomethyl ether acetate was changed to N-methyl-2-pyrrolidone. The molar absorption coefficient of a bisdithiobenzylnickel dye is $2.8 \times 10^4$, and the bisdithiobenzylnickel dye has a maximum absorbance at 860 nm. Except for the above, the cured film of Test Example 4-4 was obtained in the same manner as in Test Example 4-1.

[Test Example 4-5]

In Test Example 4-4, the amount of bisdithiobenzylnickel dye was changed to 1.0 g. Except for the above, the cured film of Test Example 4-5 was obtained in the same manner as in Test Example 4-4.

[Test Example 4-6]

In Test Example 4-1, the diimonium dye was changed to a phthalocyanine dye (the structure described in Example 1 of JP 6229875 B). The molar absorption coefficient of a phthalocyanine dye is $5.0 \times 10^4$, and the phthalo-

cyanine dye has a maximum absorbance at 920 nm. Except for the above, the cured film of Test Example 4-6 was obtained in the same manner as in Test Example 4-1.

[Test Example 4-7]

In Test Example 4-1, the amount of phthalocyanine dye was changed to 1.0 g. Except for the above, the cured film of Test Example 4-7 was obtained in the same manner as in Test Example 4-1.

[Test Example 4-8]

In Test Example 4-1, the diimonium dye was changed to a cyanine dye (formula (33) above). The molar absorption coefficient of a cyanine dye is $1.4 \times 10^5$, and the cyanine dye has a maximum absorbance at 830 nm. Except for the above, the cured film of Test Example 4-8 was obtained in the same manner as in Test Example 4-1.

[Evaluation results]

The absorbance spectra of the cured films of Test Examples 4-1 to 4-8 were obtained in the same manner as in Test Example 1.

[Evaluation results]

The calculated absorbances of the cured films of Test Examples 4-1 to 4-8 were as shown in Table 6 below. Table 6 shows the absorbance at the wavelength at which the dye of each test example exhibits the maximum absorbance.

[Table 6]

| Test Ex. | Colorant | Molar absorption coefficient | Maximum wavelength (nm) | Absorbance |
|---|---|---|---|---|
| 4-1 | Diimmonium dye | $2.2 \times 10^4$ | 960 | 0.2 |
| 4-2 | Diimmonium dye | $2.2 \times 10^4$ | 960 | 0.4 |
| 4-3 | Diimmonium dye | $2.2 \times 10^4$ | 960 | 0.5 |
| 4-4 | Bisdithiobenzylnickel dye | $2.8 \times 10^4$ | 860 | 0.2 |
| 4-5 | Bisdithiobenzylnickel dye | $2.8 \times 10^4$ | 860 | 0.3 |
| 4-6 | Phthalocyanine dye | $5.0 \times 10^4$ | 920 | 0.4 |
| 4-7 | Phthalocyanine dye | $5.0 \times 10^4$ | 920 | 0.82 |
| 4-8 | Cyanine dye | $1.4 \times 10^5$ | 830 | 0.88 |

As can be seen from Table 6, the cured film of Test Example 4-1 had an absorbance of 0.2, the cured film of Test Example 4-2 had an absorbance of 0.4, and the cured film of Test Example 4-3 had an absorbance of 0.5. In addition, a large number of precipitate clusters of the colorant were observed on the surface of the cured film of Test Example 4-3. The cured film of Test Example 4-4 had an absorbance of 0.2, and the cured film of Test Example 4-5 had an absorbance of 0.3. In addition, a large number of precipitate clusters of the colorant were observed on the surface of the cured film of Test Example 4-5. The cured film of Test Example 4-6 had an absorbance of 0.4, and the cured film of Test Example 4-7 had an absorbance of 0.82. The absorbance of the cured film of Test Example 4-8 was 0.88.

As is clear from the evaluation results of Test Examples 4-1 to 4-5, when the molar absorption coefficient of the colorant is $2.2 \times 10^4$ and when the molar absorption coefficient is $2.8 \times 10^4$, it is necessary to prepare the coating solution so that it contains a larger amount of colorant in order to obtain sufficient absorbance as an optical filter. In that case, a precipitate of the colorant appears on the surface of the cured film, and an absorbance corresponding to the amount of colorant contained in the coating solution cannot be obtained. As a result, a cured film having sufficient absorbance as an optical filter could not be obtained.

On the other hand, as is clear from the evaluation results of Test Examples 4-6 and 4-7, when the molar absorption coefficient of the colorant is $5.0 \times 10^4$, it was found that a cured film having a sufficient absorbance as an optical filter can be obtained using a coating solution containing a colorant in an amount that does not cause the colorant to precipitate and remain on the surface of the cured film.

Thus, it was found that, when the molar absorption coefficient of the colorant is $3.0 \times 10^4$ or higher, a cured

film having a thickness of 1.0 μm can exhibit sufficient absorbance as an optical filter.

As described above, according to the colored resin composition, optical filter, and method of manufacturing the optical filter, the following advantageous effects can be obtained.

(1) The copolymer includes the first and second repeating units. Since the epoxy group of the first repeating unit and the phenolic hydroxyl group of the second repeating unit form a crosslinked structure in the heating step performed to form the cured film, it is possible to prevent the heating from changing the absorbance of the cured film. In addition, since the first and second repeating units form a crosslinked structure, it is possible to prevent the dye, which is the colorant, from dissolving from the cured film when it comes into contact with the solvent used to stack another layer onto the cured film. Therefore, because the copolymer of the colored resin composition includes the first and second repeating units, the cured film formed using the colored resin composition, that is, the optical filter can have improved heat resistance and solvent resistance.

(2) The copolymer further includes the third repeating unit. The aromatic ring or alicyclic structure of the third repeating unit can create a distance between molecules of the dye, which is the colorant, close to each other that is long enough to prevent association between them by placing itself between them. This suppresses deterioration of spectral characteristics at the wavelengths at which the dye is expected to absorb light.

(3) When the percentage of the weight of the colorant to the weight of the solvent is 0.6% by weight or more, the thin-film optical filter can have sufficient absorbance as an optical filter. On the other hand, when the percentage of the weight of the colorant to the weight of the solvent is 30% by weight or less, it is possible to prevent the colorant dissolved in the solvent from precipitating and remaining on the surface of the optical filter due to the solvent volatilizing during the formation of the optical filter.

(4) When the colorant has a molar absorption coefficient of $3.0 \times 10^4$ or higher, a colored resin composition capable of achieving the absorbance required for a thin-film optical filter can be prepared.

(5) When the proportions of the first and second repeating units in the copolymer are in the above ranges, it is possible to suppress a decrease in the absorbance of the cured film after the heat treatment for forming the cured film, as well as when the cured film comes into contact with a solvent.

(6) When the proportion of the third repeating unit in the copolymer is within the above range, it is possible to prevent association between dyes during the formation of the cured film, and prevent the spectral characteristics from deteriorating at the wavelengths at which the colorant is expected to absorb light.

(7) With a glass transition temperature of 75°C or higher, when the cured film is formed using the colored resin composition of the present disclosure, it is possible to prevent the spectral characteristics from deteriorating more reliably at the wavelengths at which the colorant contained in the formed cured film is expected to absorb light.

(8) When the molecular weight of the copolymer is within the range of 30,000 or more and 150,000 or less, when the cured film is formed using the colored resin composition of the present disclosure, it is possible to prevent the spectral characteristics from deteriorating more reliably at the wavelengths at which the colorant contained in the formed cured film is expected to absorb light.

(9) Compared to the case where there is more than 20% of residual monomer, the absorbance of the cured film formed using the colored resin composition of the present disclosure is less likely to change.

## Claims

**1.** A colored resin composition comprising:

a colorant having maximum absorbance in a wavelength band of 700 nm or higher and 1100 nm or lower;
a copolymer including

a first repeating unit represented by formula (1) below and derived from an acrylic monomer having an epoxy group,
a second repeating unit derived from a monomer having a phenolic hydroxyl group, and
a third repeating unit derived from an acrylic monomer having an aromatic ring represented by formula (2) below, or a third repeating unit derived from an acrylic monomer having an alicyclic structure represented by formula (3) below; and

a solvent, wherein

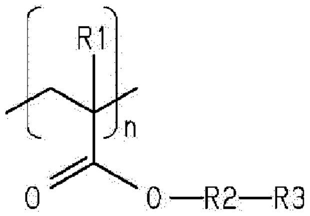

......Formula(1)

in formula (1), R1 is a hydrogen atom or a methyl group, and R2 is a single bond, a linear alkylene group having one or more carbon atoms, a branched alkylene group having three or more carbon atoms, or an oxyalkylene group having one or more carbon atoms, and
R3 is an epoxy group,

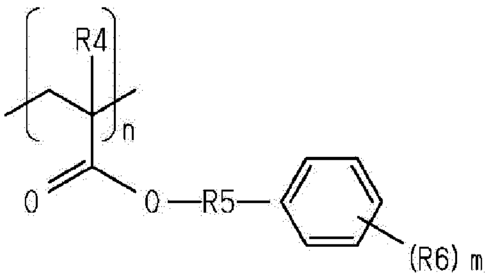

......Formula(2)

in formula (2), R4 is a hydrogen atom or a methyl group, and R5 is a single bond, a linear alkylene group having one or more carbon atoms, a branched alkylene group having three or more carbon atoms, or an oxyalkylene group having one or more carbon atoms,
R6 is a hydrogen atom or a substituent, and
in formula (2), m is an integer of 1 to 5 when R6 is a substituent, and

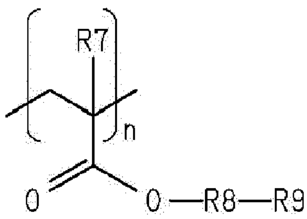

......Formula(3)

in formula (3), R7 is a hydrogen atom or a methyl group, and R8 is a single bond, a linear alkylene group having one or more carbon atoms, a branched alkylene group having three or more carbon atoms, or an oxyalkylene group having one or more carbon atoms, and
in formula (3), R9 is an alicyclic structure having three or more carbon atoms.

2. The colored resin composition according to claim 1, wherein:
a percentage of weight of the colorant to weight of the solvent is 0.6% by weight or more and 30% by weight or less.

3. The colored resin composition according to claim 1 or 2, wherein:
a molar absorption coefficient ε at a maximum absorbance wavelength of the colorant satisfies the following expression:

$$\varepsilon \geq 3.0 \times 10^4.$$

4. The colored resin composition according to any one of claims 1 to 3, wherein:

the copolymer has the first repeating unit in a proportion of 7.5% by weight or higher and 17.5% by weight or lower with respect to a total weight of the copolymer, and
in the copolymer, the ratio by weight of the second repeating unit to the first repeating unit is 1.0 or higher and 3.0 or lower.

**5.** The colored resin composition according to any one of claims 1 to 4, wherein: a proportion of the third repeating unit with respect to a total weight of the copolymer is 65% by weight or higher.

**6.** The colored resin composition according to any one of claims 1 to 5, wherein: a glass transition temperature of the copolymer is 75°C or higher.

**7.** The colored resin composition according to any one of claims 1 to 6, wherein: an average molecular weight of the copolymer is 30,000 or higher and 150,000 or lower.

**8.** The colored resin composition according to any one of claims 1 to 7, wherein: a percentage (100 × WMIW(M + P)) of weight (WM) of the monomers corresponding to the respective repeating units constituting the copolymer with respect to a sum (W(M + P)) of weight of the copolymer and the weight of the monomers is 20% or lower.

**9.** The colored resin composition according to any one of claims 1 to 8, wherein: the colorant is any one of cyanine dyes, phthalocyanine dyes, squarylium dyes, croconium dyes, diimmonium dyes, dithiol metal complex dyes, naphthalocyanine dyes, oxonol dyes, and pyrromethene dyes.

**10.** The colored resin composition according to claim 9, wherein: the colorant is a cyanine dye including

a cation having polymethine and a nitrogen-containing heterocyclic ring at each terminal end of the polymethine, and
a tris(pentafluoroethyl)trifluorophosphate anion.

**11.** An optical filter formed using the colored resin composition according to any one of claims 1 to 10, the optical filter comprising:

the colorant; and
the copolymer.

**12.** A method of manufacturing an optical filter comprising:

applying a coating solution prepared using a colored resin composition including a colorant, a copolymer, and a solvent to a substrate, and
curing the coating solution, wherein:

the colorant has maximum absorbance in a wavelength band of 700 nm or higher and 1100 nm or lower,
the copolymer includes a first, second, and third repeating units,
the first repeating unit is represented by formula (1) below and derived from an acrylic monomer having an epoxy group,
the second repeating unit is derived from a monomer having a phenolic hydroxyl group, and
the third repeating unit is derived from an acrylic monomer having an aromatic ring represented by formula (2) below, or derived from an acrylic monomer having an alicyclic structure represented by formula (3) below,

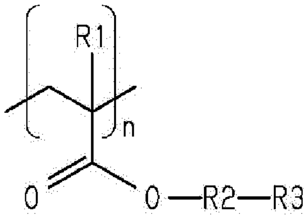
······Formula(1)

in formula (1), R1 is a hydrogen atom or a methyl group, and R2 is a single bond, a linear alkylene group having one or more carbon atoms, a branched alkylene group having three or more carbon atoms, or an oxyalkylene group having one or more carbon atoms, and
R3 is an epoxy group,

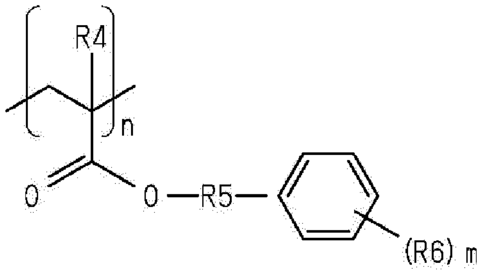

......Formula(2)

in formula (2), R4 is a hydrogen atom or a methyl group, and R5 is a single bond, a linear alkylene group having one or more carbon atoms, a branched alkylene group having three or more carbon atoms, or an oxyalkylene group having one or more carbon atoms,
R6 is a hydrogen atom or a substituent, and
in formula (2), m is an integer of 1 to 5 when R6 is a substituent, and

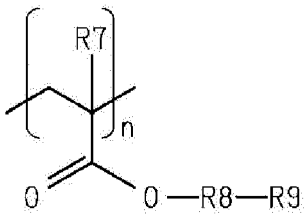

......Formula(3)

in formula (3), R7 is a hydrogen atom or a methyl group, and R8 is a single bond, a linear alkylene group having one or more carbon atoms, a branched alkylene group having three or more carbon atoms, or an oxyalkylene group having one or more carbon atoms, and
in formula (3), R9 is an alicyclic structure having three or more carbon atoms.

**13.** The method of manufacturing an optical filter according to claim 12, wherein:
in the colored resin composition, a percentage of weight of the colorant to weight of the solvent is 0.6% by weight or more and 30% by weight or less.

**14.** The method of manufacturing an optical filter according to claim 12 or 13, wherein:
a molar absorption coefficient ε at a maximum absorbance wavelength of the colorant contained in the colored resin composition satisfies the following expression:

$$\varepsilon \geq 3.0 \times 10^4.$$

INTERNATIONAL SEARCH REPORT

International application No. PCT/JP2021/047884

**A. CLASSIFICATION OF SUBJECT MATTER**

***G02B 5/22***(2006.01)i; ***C08F 220/12***(2006.01)i; ***C08F 220/32***(2006.01)i; ***C08L 33/06***(2006.01)i
FI: G02B5/22; C08F220/12; C08F220/32; C08L33/06

According to International Patent Classification (IPC) or to both national classification and IPC

**B. FIELDS SEARCHED**

Minimum documentation searched (classification system followed by classification symbols)

G02B5/22; C08F220/12; C08F220/32; C08L33/06

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| Y<br><br>A | WO 2016/194527 A1 (FUJIFILM CORP.) 08 December 2016 (2016-12-08) claims, paragraphs [0012]-[0015], [0039]-[0054], [0132], [0163]-[0169],[0245]-[0251], [0351] | 1-3, 6-14<br><br>4-5 |
| Y | JP 2006-257220 A (JSR CORP.) 28 September 2006 (2006-09-28) claims, paragraphs [0007], [0017]-[0030], [0096] | 1-3, 6-14 |
| Y | JP 2010-204151 A (SHOWA HIGHPOLYMER CO., LTD.) 16 September 2010 (2010-09-16) claims, paragraphs [0011], [0014]-[0017], [0025], [0039], [0040] | 1-3, 6-14 |
| Y | WO 2017/098996 A1 (ADEKA CORP.) 15 June 2017 (2017-06-15) claims, paragraphs [0002]-[0006], [0034]-[0056], [0100]-[0102], [0110] | 3, 10, 14 |
| Y | WO 2018/101219 A1 (ADEKA CORP.) 07 June 2018 (2018-06-07) claims, paragraphs [0016]-[0072], [0145]-[0162] | 3, 10, 14 |
| A | JP 2011-242751 A (SHINETSU CHEMICAL CO.) 01 December 2011 (2011-12-01) claims, paragraphs [0028]-[0070] | 1-14 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 March 2022** | **15 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2021/047884**

**C. DOCUMENTS CONSIDERED TO BE RELEVANT**

| Category* | Citation of document, with indication, where appropriate, of the relevant passages | Relevant to claim No. |
|---|---|---|
| A | JP 2016-204650 A (JSR CORP.) 08 December 2016 (2016-12-08) claims, paragraphs [0065]-[0080], [0138]-[0156] | 1-14 |
| P, X | WO 2021/054410 A1 (TOPPAN PRINTING CO., LTD.) 25 March 2021 (2021-03-25) claims, paragraphs [0008]-[0346] | 1-14 |
| P, X | WO 2021/145456 A1 (TOPPAN PRINTING CO., LTD.) 22 July 2021 (2021-07-22) claims, paragraphs [0024]-[0347] | 1-14 |
| E, X | WO 2022/004889 A1 (TOPPAN PRINTING CO., LTD.) 06 January 2022 (2022-01-06) claims, paragraphs [0008]-[0189] | 1-14 |

Form PCT/ISA/210 (second sheet) (January 2015)

**INTERNATIONAL SEARCH REPORT**
**Information on patent family members**

International application No.
**PCT/JP2021/047884**

| Patent document cited in search report | Publication date (day/month/year) | Patent family member(s) | Publication date (day/month/year) |
|---|---|---|---|
| WO 2016/194527 A1 | 08 December 2016 | US 2018/0118865 A1<br>claims, paragraphs [0085]-[0097], [0209]-[0244], [0410]-[0413], [0505]-[0515], [0645]-[0657], [0855]-[0861]<br>CN 107922751 A<br>TW 201700631 A<br>JP 2019-174813 A | |
| JP 2006-257220 A | 28 September 2006 | KR 10-2006-0100277 A<br>CN 1841192 A<br>TW 200643614 A | |
| JP 2010-204151 A | 16 September 2010 | US 2012/0015300 A1<br>claims, paragraphs [0021], [0029]-[0033], [0043], [0064]-[0067]<br>WO 2010/098312 A1<br>KR 10-2011-0105863 A<br>TW 201042372 A | |
| WO 2017/098996 A1 | 15 June 2017 | CN 107922745 A<br>KR 10-2018-0092930 A<br>TW 201731970 A | |
| WO 2018/101219 A1 | 07 June 2018 | CN 109642084 A<br>TW 201833242 A | |
| JP 2011-242751 A | 01 December 2011 | US 2011/0262863 A1<br>claims, paragraphs [0059]-[0111]<br>US 2014/0362980 A1<br>KR 10-2011-0118102 A<br>TW 201211098 A | |
| JP 2016-204650 A | 08 December 2016 | CN 106066578 A<br>KR 10-2016-0125893 A<br>TW 201700627 A | |
| WO 2021/054410 A1 | 25 March 2021 | JP 2021-47251 A<br>JP 2021-47252 A<br>JP 2021-47253 A | |
| WO 2021/145456 A1 | 22 July 2021 | (Family: none) | |
| WO 2022/004889 A1 | 06 January 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6395293 B
- JP 6229875 B